# EUROPEAN PATENT APPLICATION

(11) **EP 4 760 694 A1**
(43) Date of publication of application: **17.06.2026**
(21) Application number: 23951141.3
(22) Date of filing: 06.09.2023
(51) Int. Cl.: G09G 3/3233, H10K 59/121, H10K 59/131, H10K 59/35

(54) **DISPLAY SUBSTRATE AND PREPARATION METHOD THEREFOR, AND DISPLAY APPARATUS**

(71) Applicant: Boe Technology Group Co., Ltd., Beijing 100015 (CN); Beijing BOE Technology Development Co., Ltd., Beijing 100176 (CN)
(72) Inventor: HAN, Ying, Beijing 100176 (CN); YUAN, Zhidong, Beijing 100176 (CN); XU, Pan, Beijing 100176 (CN); LIU, Xiuting, Beijing 100176 (CN); LV, Guangshuang, Beijing 100176 (CN); ZHAO, Donghui, Beijing 100176 (CN); ZHANG, Xing, Beijing 100176 (CN); LUO, Chengyuan, Beijing 100176 (CN); CHU, Mingi, Beijing 100176 (CN); ZHOU, Dandan, Beijing 100176 (CN); ZHANG, Dacheng, Beijing 100176 (CN)
(74) Representative: CMS Cameron McKenna Nabarro Olswang LLP
(86) International application number: PCT/CN2023/117231
(87) International publication number: WO 2025/050314

(57) **Abstract**

A display substrate and a preparation method therefor, and a display apparatus. The display substrate comprises a plurality of repeating units (100). Each repeating unit (100) comprises at least one first power source line (51), at least one compensation signal line (53), at least two data signal line groups, and a plurality of sub-pixels, wherein the plurality of sub-pixels form at least two pixel rows and at least two pixel columns, each data signal line group comprises at least two data signal lines (52), and each sub-pixel comprises a storage capacitor (60); the first power source line (51) and the compensation signal line (53) are arranged between two adjacent pixel columns in the repeating unit (100), and the at least two data signal line groups are respectively arranged at two sides of the repeating unit (100) in a pixel row direction; and the storage capacitor (60) is arranged between the data signal line (52) and the first power source line (51), or the storage capacitor (60) is arranged between the data signal line (52) and the compensation signal line (53).

## Description

### Technical Field

The present disclosure relates to, but is not limited to, the field of display technologies, and in particular to a display substrate, a preparation method therefor, and a display apparatus.

### Background

An Organic Light Emitting Diode (OLED for short) and a Quantum dot Light Emitting Diode (QLED for short) are active light emitting display devices and have advantages such as self-luminescence, wide viewing angle, high contrast ratio, low power consumption, very high response speed, lightness and thinness, flexibility, and low cost. With continuous development of display technologies, a display apparatus in which an OLED or a QLED is used as a light emitting device and a Thin Film Transistor (TFT) is used for signal control has become a mainstream product in the field of display at present.

### Summary

The following is a summary of subject matters described herein in detail. This summary is not intended to limit the protection scope of claims.

In one aspect, the present disclosure provides a display substrate, including a plurality of repeating units, and at least one repeating unit includes at least one first power supply line, at least one compensation signal line, at least two data signal line groups and a plurality of sub-pixels, wherein the plurality of sub-pixels form at least two pixel rows and at least two pixel columns, and the data signal line group includes at least two data signal lines; at least one sub-pixel includes a pixel driving circuit, and the pixel driving circuit at least includes a storage capacitor; the first power supply line and the compensation signal line are arranged between two adjacent pixel columns in the repeating unit, and the at least two data signal line groups are arranged on both sides of the repeating unit in a direction of pixel rows, respectively; and the storage capacitor is arranged between the data signal line and the first power supply line, or the storage capacitor is arranged between the data signal line and the compensation signal line.

In an exemplary implementation, the repeating unit includes a compensation signal line, and two first power supply lines which include the first one of first power supply lines and the second one of first power supply lines, the at least two data signal line groups include a first data signal line group and a second data signal line group, and the at least two pixel columns include a first pixel column and a second pixel column; the compensation signal line is arranged between the first pixel column and the second pixel column in the repeating unit; the first data signal line group is arranged on a side of the first pixel column away from the compensation signal line, and the second data signal line group is arranged on a side of the second pixel column away from the compensation signal line; the first one of first power supply lines is arranged on a side of the compensation signal line close to the first data signal line group, and the storage capacitor in the first pixel column is arranged between the first data signal line group and the first one of first power supply lines; and the second one of first power supply lines is arranged on a side of the compensation signal line close to the second data signal line group, and the storage capacitor in the second pixel column is arranged between the second data signal line group and the second one of first power supply lines.

In an exemplary implementation, the at least one repeating unit further includes two power supply connection electrodes, and the power supply connection electrode has a strip shape extending along a direction of the pixel row and is provided across the first pixel column and the second pixel column, wherein one end of the power supply connection electrode is connected to the first one of first power supply lines, and the other end of the power supply connection electrode is connected to the second one of first power supply lines, forming an annular structure for transmitting a first power supply signal within the repeating unit.

In an exemplary implementation, the at least one repeating unit further includes a power supply connection electrode, which has a strip shape extending along the direction of the pixel row and is provided across the first pixel column and the second pixel column; and an orthographic projection of the power supply connection electrode on a plane of the display substrate is not overlapped with an orthographic projection of the data signal line on the plane of the display substrate, and the orthographic projection of the power supply connection electrode on the plane of the display substrate is at least partially overlapped with an orthographic projection of the compensation signal line on the plane of the display substrate.

In an exemplary implementation, the repeating unit includes one compensation signal line and one first power supply line, the at least two data signal line groups include a first data signal line group and a second data signal line group, and the at least two pixel columns include a first pixel column and a second pixel column; the compensation signal line is arranged between the first pixel column and the second pixel column in the repeating unit, the first data signal line group is arranged on a side of the first pixel column away from the compensation signal line, and the second data signal line group is arranged on a side of the second pixel column away from the compensation signal line; the first power supply line is arranged on a side of the compensation signal line close to the second data signal line group, the storage capacitor in the first pixel column is arranged between the first data signal line group and the compensation signal line, and the storage capacitor in the second pixel column is arranged between the second data signal line group and the first power supply line.

In an exemplary implementation, the storage capacitor at least includes two electrode plates of the capacitor; in the first pixel column, there is a first distance between an edge of at least one electrode plate of the capacitor on a side close to the compensation signal line and an edge of the compensation signal line on a side close to the electrode plate of the capacitor, and in the second pixel column, there is a second distance between an edge of at least one electrode plate of the capacitor on a side close to the first power supply line and an edge of the first power supply line on a side close to the electrode plate of the capacitor, wherein the first distance is greater than or equal to the second distance.

In an exemplary implementation, the repeating unit includes one compensation signal line and one first power supply line, the at least two data signal line groups include a first data signal line group and a second data signal line group, and the at least two pixel columns include a first pixel column and a second pixel column, wherein the compensation signal line is arranged between the first pixel column and the second pixel column in the repeating unit, the first data signal line group is arranged on a side of the first pixel column away from the compensation signal line, and the second data signal line group is arranged on a side of the second pixel column away from the compensation signal line; the first power supply line is arranged on a side of the compensation signal line close to the first data signal line group, the storage capacitor in the first pixel column is arranged between the first data signal line group and the first power supply line, and the storage capacitor in the second pixel column is arranged between the second data signal line group and the compensation signal line.

In an exemplary implementation, the storage capacitor at least includes two electrode plates of the capacitor; in the first pixel column, there is a second distance between an edge of at least one electrode plate of the capacitor on a side close to the first power supply line and an edge of the first power supply line on a side close to the electrode plate of the capacitor, and in the second pixel column, there is a first distance between an edge of at least one electrode plate of the capacitor on a side close to the compensation signal line and an edge of the compensation signal line on a side close to the electrode plate of the capacitor; and the first distance and the second distance are both greater than a distance between an edge of the compensation signal line on a side close to the first power supply line and an edge of the first power supply line on a side close to the compensation signal line.

In an exemplary implementation, the repeating unit includes one first power supply line, and two compensation signal lines which include the first compensation signal line and the second compensation signal line, the at least two data signal line groups include a first data signal line group and a second data signal line group, and the at least two pixel columns include a first pixel column and a second pixel column; the first power supply line is arranged between the first pixel column and the second pixel column in the repeating unit; the first data signal line group is arranged on a side of the first pixel column away from the first power supply line, and the second data signal line group is arranged on a side of the second pixel column away from the first power supply line; the first compensation signal line is arranged on a side of the first power supply close to the first data signal line group, and the storage capacitor in the first pixel column is arranged between the first data signal line group and the first compensation signal line; and the second compensation signal line is arranged on a side of the first power supply line close to the second data signal line group, and the storage capacitor in the second pixel column is arranged between the second data signal line group and the second compensation signal line.

In an exemplary implementation, the at least one repeating unit further includes two compensation connection electrodes, and the compensation connection electrode has a strip shape extending along a direction of the pixel row and is provided across the first pixel column and the second pixel column, wherein one end of the compensation connection electrode is connected to the first compensation signal line, and the other end of the compensation connection electrode is connected to the second compensation signal line, forming an annular structure for transmitting a compensation signal within the repeating unit.

In an exemplary implementation, the at least one repeating unit further includes two compensation connection electrodes, and the compensation connection electrode has a strip shape extending along a direction of the pixel row and is provided across the first pixel columns and the second pixel column; and an orthographic projection of the compensation connection electrode on a plane of the display substrate is not overlapped with an orthographic projection of the data signal line on the plane of the display substrate, and the orthographic projection of the compensation connection electrode on the plane of the display substrate is at least partially overlapped with an orthographic projection of the first power supply line on the plane of the display substrate.

In an exemplary implementation, the repeating unit includes one compensation signal line, and one first power supply line, the at least two data signal line groups include a first data signal line group and a second data signal line group, and the at least two pixel columns include a first pixel column and a second pixel column; the first power supply line is arranged between the first pixel column and the second pixel column in the repeating unit; the first data signal line group is arranged on a side of the first pixel column away from the first power supply line, and the second data signal line group is arranged on a side of the second pixel column away from the first power supply line; the compensation signal line is arranged on a side of the first power supply close to the second data signal line group, and the storage capacitor in the first pixel column is arranged between the first data signal line group and the first power supply line, and the storage capacitor in the second pixel column is arranged between the second data signal line group and the compensation signal line; or the compensation signal line is arranged on a side of the first power supply line close to the first data signal line group, the storage capacitor in the first pixel column is arranged between the first data signal line group and the compensation signal line, and the storage capacitor in the second pixel column is arranged between the second data signal line group and the first power supply line.

In an exemplary implementation, the storage capacitor at least includes two electrode plates of the capacitor; in the first pixel column, there is a third distance between an edge of at least one electrode plate of the capacitor on a side close to the first power supply line and an edge of the first power supply line on a side close to the electrode plate of the capacitor, and in the second pixel column, there is a fourth distance between an edge of at least one electrode plate of the capacitor on a side close to the compensation signal line and an edge of the compensation signal line on a side close to the electrode plate of the capacitor; or in the first pixel column, there is a fourth distance between an edge of at least one electrode plate of the capacitor on a side close to the compensation signal line and an edge of the compensation signal line on a side close to the electrode plate of the capacitor, and in the second pixel column, there is a third distance between an edge of at least one electrode plate of the capacitor on a side close to the first power supply line and an edge of the first power supply line on a side close to the electrode plate of the capacitor; and the third distance and the fourth distance are both greater than a distance between an edge of the compensation signal line on a side close to the first power supply line and an edge of the first power supply line on a side close to the compensation signal line.

In an exemplary implementation, the storage capacitor at least includes two electrode plate of the capacitors, and in at least one pixel column, the distance between an edge of at least one electrode plate of the capacitor on a side close to the compensation signal line and an edge of the compensation signal line on a side close to the electrode plate of the capacitor is greater than or equal to 3 microns.

In an exemplary implementation, the storage capacitor includes a first electrode plate and a second electrode plate, and the pixel driving circuit further includes a first transistor, a second transistor and a third transistor, wherein a first electrode of the first transistor is connected to the data signal line, a second electrode of the first transistor is connected to the first electrode plate and a gate electrode of the second transistor, respectively, a first electrode of the third transistor is connected to the compensation signal line, and a second electrode of the third transistor is connected to the second electrode plate and a second electrode of the second transistor, respectively; and in the at least one repeating unit, gate electrodes of a plurality of the first transistors and gate electrodes of a plurality of the third transistors are connected to the same scan signal line.

In an exemplary implementation, the first transistor at least includes a first active layer, wherein a first region of the first active layer is connected to the data signal line through a connection electrode, and a second region of the first active layer is connected to the second electrode plate; and in the at least one sub-pixel, an orthographic projection of the first active layer on the plane of the display substrate is not overlapped with an orthographic projection of the data signal line on the plane of the display substrate.

In an exemplary implementation, the third transistor at least includes a third active layer, wherein a first region of the third active layer is connected to the compensation signal line through a connection electrode, and a second region of the third active layer is connected to the first electrode plate; and in the at least one sub-pixel, an orthographic projection of the third active layer on the plane of the display substrate is not overlapped with an orthographic projection of the first power supply line on the plane of the display substrate.

In another aspect, the present disclosure also provides a display apparatus, including the display substrate described above.

In another aspect, the present disclosure further provides a preparation method for a display substrate including a plurality of repeating units, the method preparation includes:
forming at least one first power supply line, at least one compensation signal line, at least two data signal line groups, and a plurality of sub-pixels in at least one repeating unit, wherein a plurality of sub-pixels form at least two pixel rows and at least two pixel columns, and the data signal line group at least includes one data signal line; at least one sub-pixel includes a pixel driving circuit, and the pixel driving circuit at least includes a storage capacitor; the first power supply line and the compensation signal line are arranged between two adjacent pixel columns in the repeating unit, and the at least two data signal line groups are respectively arranged on both sides of a direction of the pixel rows of the repeating unit; and the storage capacitor is arranged between the data signal line and the first power supply line, or the storage capacitor is arranged between the data signal line and the compensation signal line.

Other aspects may be comprehended upon reading and understanding drawings and detailed description.

### Brief Description of Drawings

Accompanying drawings are intended to provide further understanding of technical solutions of the present disclosure and form a part of the specification, and are used to explain the technical solutions of the present disclosure together with embodiments of the present disclosure, but do not form limitations on the technical solutions of the present disclosure. Shapes and sizes of various components in the drawings do not reflect actual scales, but are only intended to schematically illustrate contents of the present disclosure.
FIG. 1 is a schematic diagram of a structure of a display apparatus.
FIG. 2 is a schematic diagram of a planar structure of a display substrate according to an exemplary embodiment of the present disclosure.
FIG. 3 is an equivalent circuit diagram of a pixel driving circuit in a repeating unit according to an embodiment of the present disclosure.
FIG. 4 is a schematic diagram of a structure of a display substrate according to an embodiment of the present disclosure.
FIG. 5 is a schematic diagram of a display substrate after a pattern of a first conductive layer is formed according to the present disclosure.
FIG. 6A and FIG. 6B are schematic diagrams of a display substrate after a pattern of a second conductive layer is formed, according to the present disclosure.
FIG. 7A and FIG. 7B are schematic diagrams of a display substrate after a pattern of a semiconductor layer is formed according to the present disclosure.
FIG. 8 is a schematic diagram of a display substrate after a pattern of a second insulation layer is formed according to the present disclosure.
FIG. 9A and FIG. 9B are schematic diagrams of a display substrate after a pattern of a third conductive layer is formed, according to the present disclosure.
FIG. 10 is a schematic diagram of a display substrate after patterns of a third insulation layer and a planarization layer are formed according to the present disclosure.
FIG. 11A and FIG. 11B are schematic diagrams of a display substrate after a pattern of a fourth conductive layer is formed according to the present disclosure.
FIG. 12 is a schematic diagram of a display substrate after a pattern of a pixel definition layer is formed according to the present disclosure.
FIG. 13 is an equivalent circuit diagram of a pixel driving circuit in another repeating unit according to an embodiment of the present disclosure.
FIG. 14 is a schematic diagram of a structure of another display substrate according to an embodiment of the present disclosure.
FIG. 15 is an equivalent circuit diagram of a pixel driving circuit in yet another repeating unit according to an embodiment of the present disclosure.
FIG. 16 is a schematic diagram of a structure of another display substrate according to an embodiment of the present disclosure.
FIGS. 17A and 17B are schematic diagrams of yet another display substrate after a pattern of a second conductive layer is formed, according to the present disclosure.
FIG. 18A and FIG. 18B are schematic diagrams of another display substrate after a pattern of a semiconductor layer is formed according to the present disclosure.
FIG. 19 is a schematic diagram of another display substrate after a pattern of a second insulation layer is formed according to the present disclosure.
FIG. 20A and FIG. 20B are schematic diagrams of yet another display substrate after a pattern of a third conductive layer is formed according to the present disclosure.
FIG. 21 is an equivalent circuit diagram of a pixel driving circuit in yet another repeating unit according to an embodiment of the present disclosure.
FIG. 22 is a schematic diagram of a structure of another display substrate according to an embodiment of the present disclosure.
FIG. 23 is a schematic structural diagram of another display substrate according to an embodiment of the present disclosure; and
FIG. 24 is a schematic diagram of still another display substrate after a pattern of a first conductive layer is formed according to the present disclosure.
FIGS. 25A and 25B are schematic diagrams of still another display substrate after a pattern of a second conductive layer is formed, according to the present disclosure.
FIG. 26A and FIG. 26B are schematic diagrams of still another display substrate after a pattern of a semiconductor layer is formed according to the present disclosure.
FIG. 27 is a schematic diagram of still another display substrate after a pattern of a second insulation layer is formed according to the present disclosure.
FIG. 28A and FIG. 28B are schematic diagrams of still another display substrate after a pattern of a third conductive layer is formed, according to the present disclosure.

Reference signs are described as follows.
11-First connection 12-Second connection 13-Third connection electrode; electrode; electrode;
14-Fourth connection 15-Fifth connection 16-Sixth connection electrode; electrode; electrode;
17-Data connection 18-power supply 19-Compensation electrode; connection electrode; connection electrode;
20-Tenth connection 21-First active layer; 22-Second active layer; electrode;
23-Third active layer; 30-Scan signal line 31-First gate electrode;
32-Second gate 41-Data bridging 33-Third gate electrode; electrode; electrode;
42-Compensation 51-First power supply 52-Data signal line; bridging electrode; line;
53-Compensation signal 60-Storage capacitor; 61-First electrode plate; line;
62-Second electrode 70-First electrode; 100-Repeating unit; plate;

### Detailed Description

To make the objectives, technical solutions, and advantages of the present disclosure clearer, the embodiments of the present disclosure will be described in detail below with reference to the accompany drawings. Implementations may be implemented in a plurality of different forms. Those of ordinary skills in the art can easily understand such a fact that Implementations and contents may be transformed into various forms without departing from the purpose and scope of the present disclosure. Therefore, the present disclosure should not be explained as being limited to the contents recorded in the following implementations only. The embodiments and features in the embodiments of the present disclosure may be randomly combined with each other if there is no conflict.

Scales of the drawings in the present disclosure may be used as a reference in actual processes, but are not limited thereto. For example, a width-length ratio of a channel, a thickness and spacing of each film, and a width and spacing of each signal line may be adjusted according to actual needs. A quantity of pixels in a display substrate and a quantity of sub-pixels in each pixel are not limited to numbers shown in the drawings. The drawings described in the present disclosure are schematic structural diagrams only, and one mode of the present disclosure is not limited to shapes, numerical values, or the like shown in the drawings.

Ordinal numerals "first", "second", "third", etc., in the specification are set not to form limits in numbers but only to avoid confusion between composition elements.

In the specification, for convenience, expressions "central", "above", "below", "front", "back", "vertical", "horizontal", "top", "bottom", "inside", "outside", etc., indicating directional or positional relationships are used to illustrate positional relationships between the composition elements, not to indicate or imply that involved devices or elements are required to have specific orientations and be structured and operated with the specific orientations but only to easily and simply describe the present specification, and thus should not be understood as limitations on the present disclosure. The positional relationships between the constituent elements may be changed as appropriate according to a direction according to which each constituent element is described. Therefore, appropriate replacements based on situations are allowed, which is not limited to the expressions in the specification.

In the specification, unless otherwise specified and defined, terms "mounting", "mutual connection", and "connection" should be understood in a broad sense. For example, a connection may be fixed connection, or a detachable connection, or an integral connection; it may be a mechanical connection or an electrical connection; it may be a direct connection, or an indirect connection through middleware, or internal communication inside two elements. Those of ordinary skills in the art may understand specific meanings of the above terms in the present disclosure according to specific situations.

In the specification, a transistor refers to an element that at least includes three terminals, i.e., a gate electrode, a drain electrode, and a source electrode. The transistor has a channel region between the drain electrode (drain electrode terminal, drain region, or drain) and the source electrode (source electrode terminal, source region, or source), and a current can flow through the drain electrode, the channel region, and the source electrode. It is to be noted that in the specification, the channel region refers to a region through which a current mainly flows.

In the specification, a first electrode may be a drain electrode, and a second electrode may be a source electrode. Or, the first electrode may be a source electrode, and the second electrode may be a drain electrode. In a case that transistors with opposite polarities are used, or in a case that a direction of a current changes during operation of a circuit, or the like, functions of the "source electrode" and the "drain electrode" are sometimes interchangeable. Therefore, the "source electrode" and the "drain electrode", as well as the "source terminal" and the "drain terminal", are interchangeable in the specification.

In the specification, "electrical connection" includes connection of composition elements through an element with a certain electrical action. An "element with a certain electrical action" is not particularly limited as long as electrical signals between the connected constituent elements may be sent and received. Examples of the "element with the certain electrical action" not only include an electrode and a wiring, but also include a switching element such as a transistor, a resistor, an inductor, a capacitor, another element with various functions, etc.

In the specification, "parallel" refers to a state in which an angle formed by two straight lines is -10° or more and 10° or less, and thus also includes a state in which the angle is -5° or more and 5° or less. In addition, "perpendicular" refers to a state in which an angle formed by two straight lines is 80° or more and 100° or less, and thus also includes a state in which the angle is 85° or more and 95° or less.

In the specification, a "film" and a "layer" are interchangeable. For example, a "conductive layer" may be replaced with a "conductive thin film" sometimes. Similarly, an "insulation film" may be replaced with an "insulation layer" sometimes.

Triangle, rectangle, trapezoid, pentagon, hexagon, etc. in this specification are not strictly defined, and they may be approximate triangle, rectangle, trapezoid, pentagon, hexagon, etc. There may be some small deformations caused by tolerance, and there may be chamfer, arc edge, deformation, etc.

In the present disclosure, "about" refers to that a boundary is not defined so strictly and numerical values within a range of process and measurement errors are allowed.

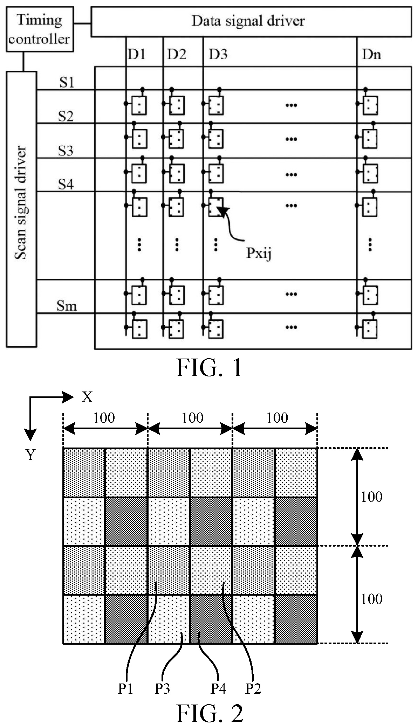

FIG. 1 is a schematic diagram of a structure of a display apparatus. As shown in FIG. 1, an OLED display apparatus may include a timing controller, a data driver, a scan driver, and a pixel array. The timing controller is connected with the data driver and the scan driver respectively, the data driver is connected with a plurality of data signal lines (D1 to Dn) respectively, and the scan driver is connected with a plurality of scan signal lines (S1 to Sm) respectively. The sub-pixel array may include a plurality of sub-pixels Pxij. Each sub-pixel Pxij may be connected with a corresponding data signal line and a corresponding scan signal line, wherein i and j may be natural numbers. At least one sub-pixel Pxij may include at least a circuit unit and a display unit. The circuit unit may include at least a pixel driving circuit connected with a scan signal line and a data signal line, respectively. The display unit may include at least a light emitting device connected with the pixel driving circuit of the circuit unit, and the sub-pixel PXij may refer to a sub-pixel in which a pixel driving circuit is connected with an i-th scan signal line and a j-th data signal line. In an exemplary implementation, the timing controller may provide a control signal and a gray scale value suitable for the specification of the data driver to the data driver, and may provide a scan start signal, a clock signal suitable for the specification of the scan driver and the like to the scan driver. The data driver may generate data voltages to be provided to the data signal lines D1, D2, D3, ..., and Dn using the grayscale value and the control signal that are received from the timing controller. For example, the data driver may sample the gray scale value using the clock signal and apply a data voltage corresponding to the gray scale value to the data signal lines D1 to Dn by taking a pixel row as a unit, wherein n may be a natural number. The scan driver may generate a scan signals to be provided to the scan signal lines S1, S2, S3, ..., and Sm by receiving the clock signal and the scan start signal from the timing controller. For example, the scan driver may sequentially provide a scan signal with an on-level pulse to the scan signal lines S1 to Sm. For example, the scan driver may be constructed in a form of a shift register and generate a scan signal in a manner of sequentially transmitting scan start signals provided in a form of an on-level pulse to a next-stage circuit under control of the clock signal, wherein m may be a natural number. In an exemplary implementation, the pixel array may be disposed on the display substrate.

An exemplary embodiment of the present disclosure provides a display substrate, including a plurality of repeating units, and at least one repeating unit includes at least one first power supply line, at least one compensation signal line, at least two data signal line groups and a plurality of sub-pixels, wherein the plurality of sub-pixels form at least two pixel rows and at least two pixel columns, and the data signal line group includes at least one data signal line; at least one sub-pixel includes a pixel driving circuit, and the pixel driving circuit at least includes a storage capacitor; the first power supply line and the compensation signal line are arranged between two adjacent pixel columns in the repeating unit, and the at least two data signal line groups are respectively arranged on both sides of a direction of pixel rows in the repeating unit; and the storage capacitor is arranged between the data signal line and the first power supply line, or the storage capacitor is arranged between the data signal line and the compensation signal line.

In an exemplary implementation, the repeating unit includes a compensation signal line, and two first power supply lines which include the first one of first power supply lines and the second one of first power supply lines, the at least two data signal line groups include a first data signal line group and a second data signal line group, and the at least two pixel columns include a first pixel column and a second pixel column; the compensation signal line is arranged between the first pixel column and the second pixel column in the repeating unit; the first data signal line group is arranged on a side of the first pixel column away from the compensation signal line, and the second data signal line group is arranged on a side of the second pixel column away from the compensation signal line; the first one of first power supply lines is arranged on a side of the compensation signal line close to the first data signal line group, and the storage capacitor in the first pixel column is arranged between the first data signal line group and the first one of first power supply lines; and the second one of first power supply lines is arranged on a side of the compensation signal line close to the second data signal line group, and the storage capacitor in the second pixel column is arranged between the second data signal line group and the second one of first power supply lines.

In an exemplary implementation, the repeating unit includes one compensation signal line and one first power supply line, the at least two data signal line groups include a first data signal line group and a second data signal line group, and the at least two pixel columns include a first pixel column and a second pixel column; the compensation signal line is arranged between the first pixel column and the second pixel column in the repeating unit, the first data signal line group is arranged on a side of the first pixel column away from the compensation signal line, and the second data signal line group is arranged on a side of the second pixel column away from the compensation signal line; the first power supply line is arranged on a side of the compensation signal line close to the second data signal line group, the storage capacitor in the first pixel column is arranged between the first data signal line group and the compensation signal line, and the storage capacitor in the second pixel column is arranged between the second data signal line group and the first power supply line.

In an exemplary implementation, the repeating unit includes one compensation signal line and one first power supply line, the at least two data signal line groups include a first data signal line group and a second data signal line group, and the at least two pixel columns include a first pixel column and a second pixel column, wherein the compensation signal line is arranged between the first pixel column and the second pixel column in the repeating unit, the first data signal line group is arranged on a side of the first pixel column away from the compensation signal line, and the second data signal line group is arranged on a side of the second pixel column away from the compensation signal line; the first power supply line is arranged on a side of the compensation signal line close to the first data signal line group, the storage capacitor in the first pixel column is arranged between the first data signal line group and the first power supply line, and the storage capacitor in the second pixel column is arranged between the second data signal line group and the compensation signal line.

In an exemplary implementation, the repeating unit includes one first power supply line, and two compensation signal lines which include the first compensation signal line and the second compensation signal line, the at least two data signal line groups include a first data signal line group and a second data signal line group, and the at least two pixel columns include a first pixel column and a second pixel column; the first power supply line is arranged between the first pixel column and the second pixel column in the repeating unit; the first data signal line group is arranged on a side of the first pixel column away from the first power supply line, and the second data signal line group is arranged on a side of the second pixel column away from the first power supply line; the first compensation signal line is arranged on a side of the first power supply close to the first data signal line group, and the storage capacitor in the first pixel column is arranged between the first data signal line group and the first compensation signal line; and the second compensation signal line is arranged on a side of the first power supply line close to the second data signal line group, and the storage capacitor in the second pixel column is arranged between the second data signal line group and the second compensation signal line.

In an exemplary implementation, the repeating unit includes one compensation signal line, and one first power supply line, the at least two data signal line groups include a first data signal line group and a second data signal line group, and the at least two pixel columns include a first pixel column and a second pixel column; the first power supply line is arranged between the first pixel column and the second pixel column in the repeating unit; the first data signal line group is arranged on a side of the first pixel column away from the first power supply line, and the second data signal line group is arranged on a side of the second pixel column away from the first power supply line; the compensation signal line is arranged on a side of the first power supply close to the second data signal line group, the storage capacitor in the first pixel column is arranged between the first data signal line group and the first power supply line, and the storage capacitor in the second pixel column is arranged between the second data signal line group and the compensation signal line.

In an exemplary implementation, the repeating unit includes one compensation signal line, and one first power supply line, the at least two data signal line groups include a first data signal line group and a second data signal line group, and the at least two pixel columns include a first pixel column and a second pixel column; the first power supply line is arranged between the first pixel column and the second pixel column in the repeating unit; the first data signal line group is arranged on a side of the first pixel column away from the first power supply line, and the second data signal line group is arranged on a side of the second pixel column away from the first power supply line; and the compensation signal line is arranged on a side of the first power supply line close to the first data signal line group, the storage capacitor in the first pixel column is arranged between the first data signal line group and the compensation signal line, and the storage capacitor in the second pixel column is arranged between the second data signal line group and the first power supply line.

The display substrate in the present disclosure is illustrated with examples below through some exemplary embodiments.

FIG. 2 is a schematic diagram of a planar structure of a display substrate according to an exemplary embodiment of the present disclosure. As shown in FIG. 2, in an exemplary implementation, the display substrate may include a plurality of repeating units 100 in a direction parallel to the display substrate, and at least one repeating unit 100 may include a plurality of sub-pixels. In an exemplary implementation, the repeating units are basic units constituting the display substrate, and the display substrate is constructed by repeating and continuously disposing the repeating units along at least one direction, i.e., the display substrate is formed by splicing a plurality of repeating units.

In an exemplary implementation, at least one repeating unit 100 may include four sub-pixels, the four sub-pixels may include a first sub-pixel P1 that emits a first color light, a second sub-pixel P2 that emits a second color light, a third sub-pixel P3 that emits a third color light, and a fourth sub-pixel P4 that emits a fourth color light. The four sub-pixels may be arranged in a square so that an aperture ratio and a light transmission area can be effectively increased.

In an exemplary implementation, in at least one repetitive unit 100, the second sub-pixel P2 may be disposed on a side of the first sub-pixel P1 in a first direction X, the third sub-pixel P3 may be disposed on a side of the first sub-pixel P1 in a second direction Y, the fourth sub-pixel P4 may be disposed on a side of the third sub-pixel P3 in the first direction X, a plurality of sub-pixels sequentially disposed along the first direction X may be referred to as a pixel row, a plurality of sub-pixels sequentially disposed along the second direction Y may be referred to as a pixel column, a plurality of pixel rows and a plurality of pixel columns constitute a pixel array arranged in an array, and the first direction X intersects with the second direction Y.

In an exemplary implementation, the first sub-pixel P1 may be a red sub-pixel (R) emitting red light, the second sub-pixel P2 may be a blue sub-pixel (B) emitting blue light, the third sub-pixel P3 may be a white sub-pixel (W) emitting white light, and the fourth sub-pixel P4 may be a green sub-pixel (G) emitting green light. In some possible implementations, an arrangement mode of RBWG may be adjusted according to actual needs, and the present disclosure is not specifically limited thereto.

In an exemplary implementation, in a direction perpendicular to the display substrate, the display substrate may at least include a drive circuit layer provided on the base substrate and a light emitting structure layer provided on a side of the drive circuit layer away from the base substrate. In at least one repeating unit, the drive circuit layer may include a plurality of circuit units. A circuit unit may at least include a pixel driving circuit, and the pixel driving circuit is connected to a scan signal line, a data signal line and the like respectively. The pixel driving circuit is configured to receive a data voltage transmitted by the data signal line and output a corresponding current to a light emitting device under control of the scan signal line. The light emitting structure layer may include a plurality of light emitting units, and a light emitting unit may include at least a light emitting device. The light emitting device is connected with a pixel driving circuit of a circuit unit of a sub-pixel in which the light emitting device is located, and the light emitting device is configured to emit light with corresponding brightness in response to a current output by the pixel driving circuit of the sub-pixel in which the light emitting device is located.

In another exemplary implementation, in a direction perpendicular to the display substrate, the display substrate may at least include a drive circuit layer provided on the base substrate, a color filter structure layer provided on a side of the drive circuit layer away from the base substrate, and a light emitting structure layer provided on a side of the color filter structure layer away from the base substrate. In at least one repeating unit, the color filter structure layer may include a plurality of color filter units. A color filter unit may at least include a color filter layer, and the color filter layer is configured to enable a corresponding sub-pixel to emit light of a desired color.

In an exemplary implementation, the circuit unit mentioned in the present disclosure refers to a region divided by a pixel driving circuit. The color film unit mentioned in the present disclosure refers to a region divided by a color filter layer. The display unit mentioned in the present disclosure refers to a region divided by a light emitting device. Positions of an orthographic projection of a circuit unit on the base substrate, an orthographic projection of a color filter layer on the base substrate, and an orthographic projection of a light emitting unit on the base substrate may or may not correspond.

In an exemplary embodiment of the present disclosure, the positions of an orthographic projection of a circuit unit on the base substrate, an orthographic projection of a color filter layer on the base substrate, and an orthographic projection of a light emitting unit on the base substrate are in one-to-one correspondence. The circuit unit, the color film unit, and the light emitting unit constitute a sub-pixel, so a sub-pixel is uniformly used to refer to a circuit unit, a color film unit, and a light emitting unit in the following.

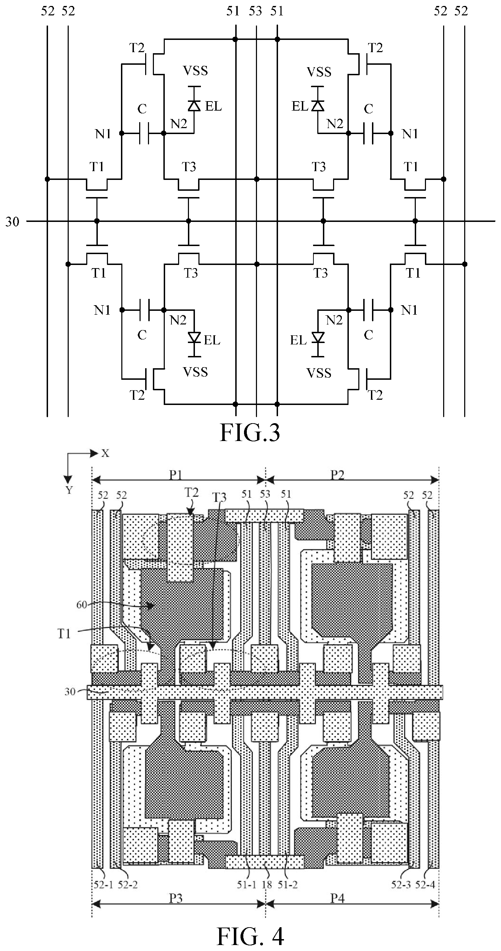

FIG. 3 is an equivalent circuit diagram of a pixel driving circuit in a repeating unit according to an exemplary embodiment of the present disclosure. As shown in FIG. 3, at least one repeating unit may include four pixel driving circuits, the four pixel driving circuits may be arranged in a square manner, and the pixel driving circuits may be of a 3T1C structure.

In an exemplary implementation, at least one pixel driving circuit may include three transistors (a first transistor T1, a second transistor T2, and a third transistor T3) and one storage capacitor C. The pixel driving circuit is connected with a scan signal line 30, a first power supply line 51, a data signal line 52, and a compensation signal line 53, respectively.

In an exemplary implementation, each pixel driving circuit may include a first node N1 and a second node N2. The first node N1 is connected with a second electrode of the first transistor T1, a gate electrode of the second transistor T2 and a first end of the storage capacitor C, respectively, and the second node N2 is connected with a second electrode of the second transistor T2, a second electrode of the third transistor T3 and a second end of the storage capacitor C, respectively.

In an exemplary implementation, the first end of the storage capacitor C is connected with the first node N1, the second end of the storage capacitor C is connected with the second node N2, and the storage capacitor C is configured to store a potential of the gate electrode of the second transistor T2.

In an exemplary implementation, the first transistor T1 is a switch transistor, the second transistor T2 is a drive transistor, and the third transistor T3 is a compensation transistor.

In an exemplary implementation, a gate electrode of the first transistor T1 is connected with the scan signal line 30, a first electrode of the first transistor T1 is connected with the data signal line 52, and a second electrode of the first transistor T1 is connected with the first node N1. When a turned-on signal is applied to the scan signal line 30, the first transistor T1 inputs a data signal of the data signal line 52 to the gate electrode of the second transistor T2.

In an exemplary implementation, the gate electrode of the second transistor T2 is connected with the first node N1, a first electrode of the second transistor T2 is connected with the first power supply line 51, and the second electrode of the second transistor T2 is connected with the second node N2. The second transistor T2 generates a corresponding current at the second electrode of the second transistor T2 under control of a data signal received by the gate electrode of the second transistor T2.

In an exemplary implementation, a gate electrode of the third transistor T3 is connected with the scan signal line 30, a first electrode of the third transistor T3 is connected with the compensation signal line 53, and a second electrode of the third transistor T3 is connected with the second node N2. When a turned-on signal is applied to the scan signal line 30, the third transistor T3 extracts a threshold voltage Vth and a migration rate of the second transistor T2 in response to a compensation timing, to compensate the threshold voltage Vth.

In an exemplary implementation, in a pixel driving circuit of at least one sub-pixel, a gate electrode of a first transistor T1 and a gate electrode of a third transistor T3 are connected with a same scan signal line 30.

In an exemplary implementation, in a plurality of pixel driving circuits of at least one pixel row, gate electrodes of a plurality of first transistors T1 and gate electrodes of a plurality of third transistors T3 are connected with a same scan signal line 30.

In an exemplary implementation, in a plurality of pixel driving circuits of at least one repeating unit, gate electrodes of a plurality of first transistors T1 and gate electrodes of a plurality of third transistors T3 are connected with a same scan signal line 30.

In an exemplary implementation, the light emitting device EL may be an OLED including a first electrode (anode), an organic light emitting layer, and a second electrode (cathode), which are stacked, or may be a QLED including a first electrode (anode), a quantum dot light emitting layer, and a second electrode (cathode), which are stacked. The first electrode of the light emitting device EL is connected with the second node N2, the second electrode of the light emitting device EL is connected with the second power supply line 52, and the light emitting device EL emits light with corresponding brightness in response to a current of the second electrode of the second transistor T2.

In an exemplary implementation, a signal of the first power supply line 51 is a continuously supplied high-level signal, and a signal of the second power supply line 52 is a continuously supplied low-level signal.

In an exemplary implementation, the first transistor T1 to the third transistor T3 may be P-type transistors, or may be N-type transistors. Use of a same type of transistors in a pixel driving circuit may simplify a process flow, reduce a process difficulty of a display panel, and improve a product yield. In some possible Implementations, the first transistor T1 to the third transistor T3 may include a P-type transistor and an N-type transistor.

In an exemplary implementation, for the first transistor T1 to the third transistors T3, low temperature poly silicon thin film transistors may be used, oxide thin film transistors may be used, or a low temperature poly silicon thin film transistor and an oxide thin film transistor may be used. An active layer of a low temperature poly silicon thin film transistor is made of Low Temperature Poly silicon (LTPS for short), and an active layer of an oxide thin film transistor is made of an oxide semiconductor (Oxide). The low temperature poly silicon thin film transistor has advantages, such as a high mobility and fast charging, and the oxide thin film transistor has advantages, such a low leakage current. The low temperature poly silicon thin film transistor and the oxide thin film transistor are integrated on one display substrate, that is, an LTPS + Oxide (LTPO for short) display substrate, so that advantages of the low temperature poly silicon thin film transistor and the oxide thin film transistor may be utilized, low-frequency drive may be achieved, power consumption may be reduced, and display quality may be improved.

FIG. 4 is a schematic diagram of a structure of a display substrate according to an exemplary embodiment of the present disclosure, illustrating a structure of a pixel driving circuit in a repeating unit (four sub-pixels) in a bottom emission display substrate. As shown in FIG. 4, in an exemplary implementation, at least one repeating unit may include a first sub-pixel P1, a second sub-pixel P2, a third sub-pixel P3, and a fourth sub-pixel P4 arranged in a square manner, each sub-pixel includes a pixel driving circuit.

In an exemplary implementation, at least one repeating unit may include one scan signal line 30, two first power supply lines 51, four data signal lines 52, and one compensation signal line 53, the aforementioned signal lines are respectively connected to a pixel driving circuit in a corresponding sub-pixel. The scan signal line 30 is configured to provide a scan signal to the pixel driving circuit, the first power supply lines 51 are configured to provide a power supply signal to the pixel driving circuit, the data signal lines 52 are configured to provide a data signal to the pixel driving circuit, and the compensation signal line 53 is configured to provide a compensation signal to the pixel driving circuit.

In an exemplary implementation, the scan signal line 30 may have a shape of a line with a main body portion extending along a first direction X (the pixel row direction), and the first power supply lines 51, the data signal lines 52, and the compensation signal line 53 may each have a shape of a line with a main body portion extending along a second direction (the pixel column direction), wherein the first direction X intersects with the second direction Y.

In the exemplary implementation, the scan signal line 30 may be arranged in the middle of the repeating unit in the second direction Y, and one compensation signal line 53 may be located in the middle of the repeating unit in the first direction X, so that one scan signal line 30 extending along the first direction X may define two pixel rows, and one compensation signal line 53 extending along the second direction Y may define two pixel columns, forming a first sub-pixel P1, a second sub-pixel P2, a third sub-pixel P3, and a fourth sub-pixel P4 arranged in a square manner in one repeating unit.

In an exemplary implementation, in at least one repeating unit, four sub-pixels may be mirror-symmetrical with respect to the scan signal line 30, and four sub-pixels may be mirror-symmetrical with respect to the compensation signal line 53.

In an exemplary implementation, in at least one repeating unit, two pixel columns may include a first pixel column and a second pixel column, two first power supply lines 51 may include a first one of first power supply lines 51-1 and a second one of first power supply lines 51-2 sequentially arranged along the first direction X, and four data signal lines 52 may include a first data signal line 52-1, a second data signal line 52-2, a third data signal line 52-3, and a fourth data signal line 52-4 sequentially arranged along the first direction X, wherein the first data signal line 52-1 and the second data signal line 52-2 may constitute a first data signal line group, and the third data signal line 52-3 and the fourth data signal line 52-4 may constitute a second data signal line group.

In the exemplary implementation, the compensation signal line 53, the first one of first power supply lines 51-1, and the second one of first power supply lines 51-2 may be located in the middle region of the repeating unit in the first direction X, the first data signal line group (including the first data signal line 52-1 and the second data signal line 52-2) may be located on a side of the repeating unit in a direction opposite to the first direction X, the second data signal line group (including the third data signal line 52-3 and the fourth data signal line 52-4) may be located on a side of the repeating unit in the first direction X, the first one of first power supply lines 51-1 may be located on a side of the compensation signal line 53 close to the first data signal line group, and the second one of first power supply lines 51-2 may be located on a side of the compensation signal line 53 close to the second data signal line group.

In an exemplary implementation, the pixel driving circuit of the at least one sub-pixel may at least include a storage capacitor 60, a first transistor T1, a second transistor T2, and a third transistor T3, and the storage capacitor may include a first electrode plate and a second electrode plate as electrode plates of the capacitor. The storage capacitor 60 of the first pixel column may be arranged between the first one of first power supply lines 51-1, and the second data signal line 52-2 in the first data signal line group, and the storage capacitor 60 of the second pixel column may be arranged between the second one of first power supply lines 51-2, and the third data signal line 52-3 in the second data signal line group.

In an exemplary implementation, a first electrode of the first transistor T1 is connected to a data signal line 52, a second electrode of the first transistor T1 is connected to the gate electrode of the second transistor T2 and the second electrode plate of the storage capacitor 60 respectively. A first electrode of the second transistor T2 is connected to a first power supply line 51, a first electrode of the third transistor T3 is connected to the compensation signal line 53, and a second electrode of the third transistor T3 is connected to a second electrode of the second transistor T2 and the first electrode plate of the storage capacitor 60 respectively.

In an exemplary implementation, the at least one repeating unit further includes two power supply connection electrodes 18, which may be located on a side of the repeating unit in the second direction Y, respectively. Each power supply connection electrode 18 may have a strip shape extending along the first direction X, and is provided across the first pixel column and the second pixel column. A first end of each power supply connection electrode 18 is connected to the first one of first power supply lines 51-1 and a first electrode of the second transistor T2 in the first pixel column, and a second end of each power supply connection electrode 18 is connected to the second one of first power supply lines 51-2 and a first electrode of the second transistor T2 in the second pixel column. In this way, the two first power supply lines 51 and the two power supply connection electrodes 18 within the repeating unit form an annular structure for transmitting the first power supply signal.

In an exemplary implementation, an orthographic projection of the power supply connection electrode 18 on the plane of the display substrate is not overlapped with an orthographic projection of the data signal line 52 on the plane of the display substrate.

In an exemplary implementation, an orthographic projection of the power supply connection electrode 18 on the plane of the display substrate is at least partially overlapped with an orthographic projection of the compensation signal line 53 on the plane of the display substrate.

Exemplary description is made below through a preparation process of a display substrate. A "patterning process" mentioned in the present disclosure includes photoresist coating, mask exposure, development, etching, photoresist stripping, etc., for a metal material, an inorganic material, or a transparent conductive material, and includes organic material coating, mask exposure, development, etc., for an organic material. Deposition may be any one or more of sputtering, evaporation, and chemical vapor deposition, coating may be any one or more of spray coating, spin coating, and inkjet printing, and etching may be any one or more of dry etching and wet etching, the present disclosure is not limited thereto. A "thin film" refers to a layer of thin film made of a certain material on a base substrate using deposition, coating, or other processes. If the "thin film" does not need to be processed through a patterning process in the entire preparation process, the "thin film" may also be called a "layer". If the "thin film" needs to be processed through the patterning process in the entire preparation process, the "thin film" is called a "thin film" before the patterning process is performed and is called a "layer" after the patterning process is performed. At least one "pattern" is contained in the "layer" which has been processed through the patterning process. "A and B are arranged in a same layer" in the present disclosure means that A and B are formed simultaneously through a same patterning process, and a "thickness" of a film layer is a dimension of the film layer in a direction perpendicular to a display substrate. In an exemplary embodiment of the present disclosure, "an orthographic projection of B being within a range of an orthographic projection of A" or "an orthographic projection of A containing an orthographic projection of B" means that a boundary of the orthographic projection of B falls within a range of a boundary of the orthographic projection of A, or the boundary of the orthographic projection of A is overlapped with the boundary of the orthographic projection of B.

In an exemplary implementation, taking four sub-pixels (a first sub-pixel P1, a second sub-pixel P2, a third sub-pixel P3, and a fourth sub-pixel P4) of one repeating unit as an example, a preparation process of the display substrate of the embodiment may include following operations.

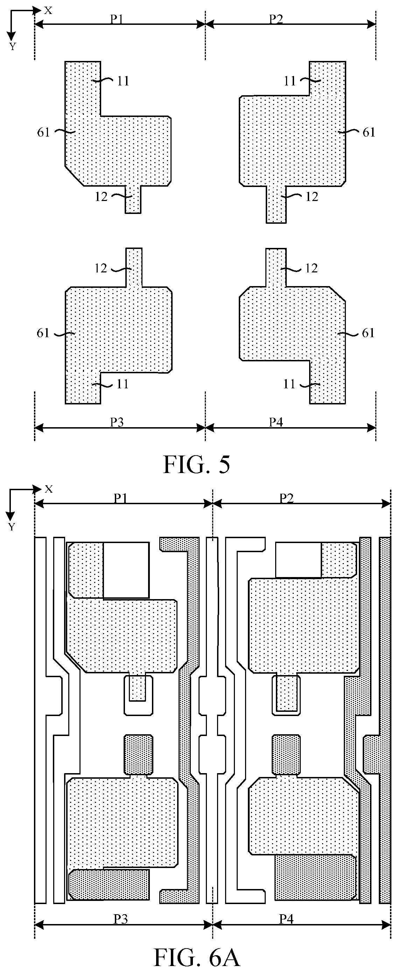

(11) A pattern of a first conductive layer is formed. In an exemplary implementation, forming the pattern of the first conductive layer includes: depositing a first conductive thin film on a base substrate, patterning the first conductive thin film through a patterning process, to form the pattern of the first conductive layer on the base substrate, as shown in FIG. 5.

In an exemplary implementation, the first conductive layer of each sub-pixel in the display substrate may at least include a first connection electrode 11, a second connection electrode 12, and a first electrode plate 61 of a storage capacitor.

In an exemplary implementation, the first electrode plate 61 may have a shape of a rectangle, corners of the rectangle may be chamfered, the first electrode plate 61 may serve as a transparent plate of a transparent storage capacitor, and the first electrode plate 61 is configured to form a transparent storage capacitor with a second electrode plate to be formed subsequently.

In an exemplary implementation, the first connection electrode 11 and the second connection electrode 12 may be on two sides of the first electrode plate 61 in the second direction Y respectively.

In an exemplary implementation, in the first sub-pixel P1 and the second sub-pixel P2, the first connection electrode 11 may be arranged on a side of the first electrode plate 61 in a direction opposite to the second direction Y, and the second connection electrode 12 may be arranged on a side of the first electrode plate 61 in the second direction Y. In the third sub-pixel P3 and the fourth sub-pixel P4, the first connection electrode 11 may be arranged on a side of the first electrode plate 61 in the second direction Y, and the second connection electrode 12 may be arranged on a side of the first electrode plate 61 in a direction opposite to the second direction Y.

In an exemplary implementation, the first connection electrode 11 may have a shape of a strip with a main body portion extending along the second direction Y, a first end of the first connection electrode 11 is connected to the first electrode plate 61, a second end of the first connection electrode 11 extends in a direction away from the second connection electrode 12, and the first connection electrode 11 is configured to be connected to a third connection electrode to be formed subsequently.

In an exemplary implementation, the second connection electrode 12 may have a shape of a strip with a main body portion extending along the second direction Y, a first end of the second connection electrode 12 is connected to the first electrode plate 61, a second end of the second connection electrode 12 extends in a direction away from the first connection electrode 11, and the second connection electrode 12 is configured to be connected to a fourth connection electrode to be formed subsequently.

In an exemplary implementation, in the first pixel column, the first connection electrode 11 may be arranged on a side away from the second pixel column, and an edge of the first connection electrode 11 on a side away from a second pixel column and an edge of the first electrode plate 61 on a side away from the second pixel column may be substantially aligned. In the second pixel column, the first connection electrode 11 may be arranged on a side away from the first pixel column, and an edge of the first connection electrode 11 on a side away from the first pixel column and an edge of the first electrode plate 61 on a side away from the first pixel column may be substantially aligned.

In an exemplary implementation, in the first direction X, a width of the first connection electrode 11 may be greater than a width of the second connection electrode 12.

In an exemplary implementation, in each sub-pixel, the second connection electrode 12 may be arranged near the middle region of the sub-pixel in the first direction X.

In an exemplary implementation, the first connection electrode 11, the second connection electrode 12, and the first electrode plate 61 of each sub-pixel may be of an interconnected integral structure.

In an exemplary implementation, an area of the first electrode plate 61 in each sub-pixel may be substantially the same, so that a capacity of a storage capacitor in each sub-pixel is substantially the same.

In an exemplary implementation, positions of respective patterns in first conductive layers in the first sub-pixel P1 and the third sub-pixel P3 may be substantially mirror-symmetrical with respect to a horizontal reference line, positions of respective patterns in first conductive layers in the second sub-pixel P2 and the fourth sub-pixel P4 may be substantially mirror-symmetrical with respect to the horizontal reference line. Positions of respective patterns in first conductive layers in the first sub-pixel P1 and the second sub-pixel P2 may be substantially mirror-symmetrical with respect to a vertical reference line, and positions of respective patterns in the third sub-pixel P3 and the fourth sub-pixel P4 may be substantially mirror-symmetrical with respect to the vertical reference line. The horizontal reference line may be a straight line extending along the first direction X and bisecting a repeating unit in the second direction Y, and the vertical reference line may be a straight line extending along the second direction Y and bisecting a repeating unit in the first direction X.

In an exemplary implementation, the first conductive layer may be made of a transparent conductive material, such as Indium Tin Oxide (ITO) or Indium Zinc Oxide (IZO).

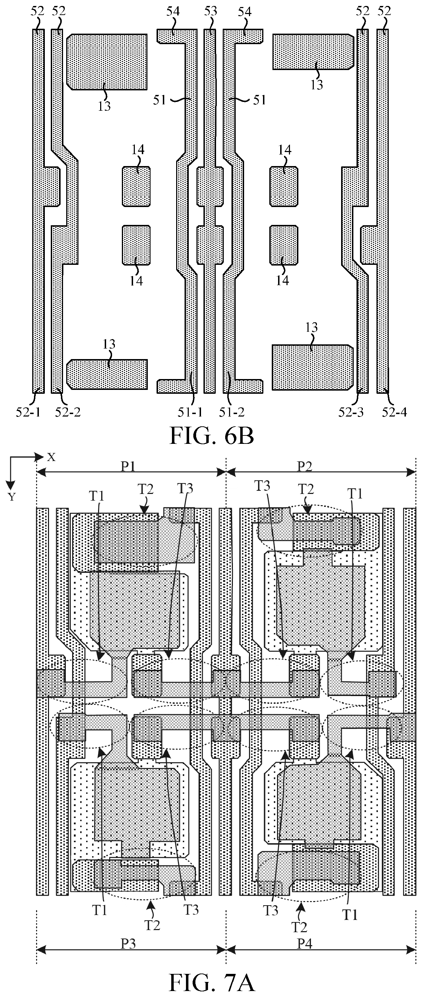

(12) A pattern of a second conductive layer is formed. In an exemplary implementation, forming the pattern of the second conductive layer may include: depositing a second conductive thin film on the base substrate on which the aforementioned pattern is formed, and patterning the second conductive thin film through a patterning process to form the second conductive layer, as shown in FIG. 6A and FIG. 6B, wherein FIG. 6B is a schematic diagram of the second conductive layer in FIG. 6A. In an exemplary implementation, the second conductive layer may be referred to as a shield layer.

In an exemplary implementation, a second conductive layer of each sub-pixel in the display substrate may include at least a third connection electrode 13 and a fourth connection electrode 14.

In an exemplary implementation, the third connection electrode 13 may have a shape of a block (for example, a rectangle), and may be located on the side of the first electrode plate 61 away from the second connection electrode 12. An orthographic projection of the third connection electrode 13 on the base substrate is at least partially overlapped with an orthographic projection of the first connection electrode 11 on the base substrate, and the third connection electrode 13 is directly overlapped with the first connection electrode 11. In an exemplary implementation, on one hand, the third connection electrode 13 is configured to be connected with a fifth connection electrode to be formed subsequently, and, on the other hand, the third connection electrode 13 is configured to shade a second transistor, so as to reduce an intensity of light irradiated on the second transistor, reduce a leakage current of the second transistor, thereby reducing an influence of illumination on characteristics of the second transistor.

In an exemplary implementation, the fourth connection electrode 14 may have a shape of a block (for example, a rectangle), and may be located on a side of the first electrode plate 61 away from the first connection electrode 11. An orthographic projection of the fourth connection electrode 14 on the base substrate is at least partially overlapped with an orthographic projection of the second connection electrode 12 on the base substrate, and the fourth connection electrode 14 is directly overlapped with the second connection electrode 12, and the fourth connection electrode 14 is configured to be connected to a sixth connection electrode to be formed subsequently.

In an exemplary implementation, in the first direction X, a width of the third connection electrode 13 may be greater than a width of the fourth connection electrode 14.

In an exemplary implementation, a second conductive layer of each repeating unit in the display substrate may include at least two first power supply lines 51, four data signal lines 52, and one compensation signal line 53.

In the exemplary embodiment, the first power supply line 51, the data signal line 52, and the compensation signal line 53 may each have a straight line shape or a polygonal line shape in which a main body portion extends along the second direction Y. The compensation signal line 53 may be located in the middle of the repeating unit in the first direction X, the two first power supply lines 51 may be located on both sides of the compensation signal line 53 in the first direction X, the first data signal line group among the four data signal lines 52 may be located on a side of the repeating unit in a direction opposite to the first direction X, and the second data signal line group among the four data signal lines 52 may be located on a side of the repeating unit in the first direction X.

In an exemplary implementation, the two first power supply lines 51 may include the first one of first power supply lines 51-1 and the second one of first power supply lines 51-2 sequentially arranged along the first direction X, and the four data signal lines 52 may include a first data signal line group and a second data signal line group, wherein the first data signal line group includes a first data signal line 52-1 and a second data signal line 52-2 sequentially arranged along the first direction X, and the second data signal line group may include a third data signal line 52-3 and a fourth data signal line 52-4 sequentially arranged along the first direction X.

In an exemplary implementation, the first data signal line 52-1 and the compensation signal line 53 may define a first pixel column, and the second data signal line 52-2 and the first one of first power supply lines 51-1 are arranged in the first pixel column. The second data signal line 52-2 may be arranged on a side of the first data signal line 52-1 close to the compensation signal line 53, and the first one of first power supply lines 51-1 may be arranged on a side of the compensation signal line 53 close to the first data signal line 52-1. The first electrode 61, the third connection electrode 13, and the fourth connection electrode 14 may be arranged between the second data signal line 52-2 and the first one of first power supply lines 51-1.

In an exemplary implementation, the fourth data signal line 52-4 and the compensation signal line 53 may define a second pixel column, and the second one of first power supply lines 51-2 and the third data signal line 52-3 are arranged in the second pixel column. The second one of first power supply lines 51-2 may be arranged on a side of the compensation signal line 53 close to the fourth data signal line 52-4, and the third data signal line 52-3 may be provided on a side of the fourth data signal line 52-4 close to the compensation signal line 53. The first electrode 61, the third connection electrode 13 and the fourth connection electrode 14 may be arranged between the second one of first power supply lines 51-2 and the third data signal line 52-3.

In an exemplary implementation, the first power supply line 51 may be provided with a power supply connection block 54. The power supply connection block 54 may have a block shape (e.g. rectangle), a first end of the power supply connection block 54 is connected to the first power supply line 51, a second end of the power supply connection block 54 extends in a direction away from the compensation signal line 53, and the power supply connection block 54 is configured to be connected to the first region of the second active layer through the power supply connection electrode formed subsequently.

In an exemplary implementation, the first power supply lines 51, the data signal lines 52, and the compensation signal line 53 may be polygonal lines with non-equal widths, and adopting polygonal lines with variable widths may not only facilitate a layout of the pixel structure, but also reduce a parasitic capacitance.

In an exemplary implementation, an orthographic projection of the compensation signal line 53 on the base substrate is at least overlapped with an orthographic projection of the vertical reference line on the base substrate, positions of the two first power supply lines 51 may be substantially mirror-symmetrical with respect to the vertical reference line, and positions of the two data signal lines 52 located on a side of the compensation signal line 53 in a direction opposite to the first direction X and positions of the two data signal lines 52 located on a side of the compensation signal line 53 in the first direction X may be substantially mirror-symmetrical with respect to the vertical reference line.

In an exemplary implementation, for the third connection electrode 13, the fourth connection electrode 14 and the power supply connection block 54, positions of these patterns in the first sub-pixel P1 and the third sub-pixel P3 may be substantially mirror-symmetrical with respect to the horizontal reference line, positions of these patterns in the second sub-pixel P2 and the fourth sub-pixel P4 may be substantially mirror-symmetrical with respect to the horizontal reference line, positions of these patterns in the first sub-pixel P1 and the second sub-pixel P2 may be substantially mirror-symmetrical with respect to the vertical reference line, and positions of these patterns in the third sub-pixels P3 and the fourth sub-pixel P4 may be substantially mirror-symmetrical with respect to the vertical reference line.

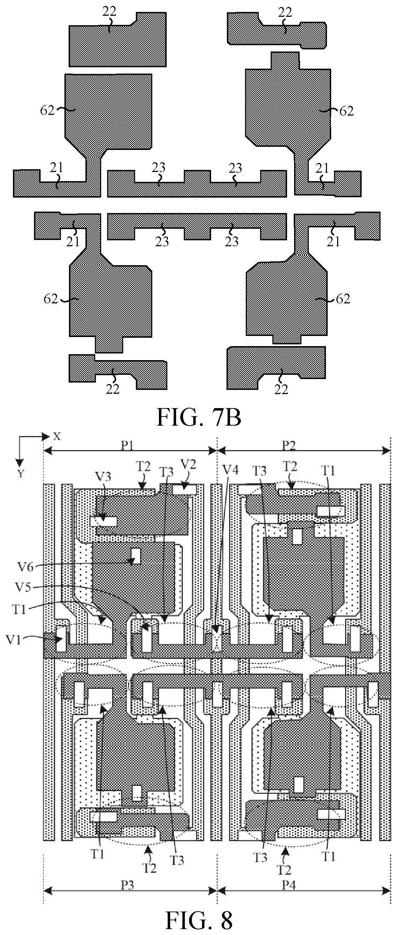

(13) A pattern of a semiconductor layer is formed. In an exemplary implementation, forming the pattern of the semiconductor layer may include: depositing a first insulation thin film and a semiconductor thin film sequentially on the base substrate on which the aforementioned patterns are formed, and patterning the semiconductor thin film through a patterning process to form a first insulation layer that covers the first conductive layer and the second conductive layer, and the semiconductor layer disposed on the first insulation layer, as shown in FIG. 7A and FIG. 7B, wherein FIG. 7B is a schematic diagram of the semiconductor layer in FIG. 7A.

In an exemplary implementation, the semiconductor layer of each sub-pixel in the display substrate may at least include a first active layer 21, a second active layer 22, a third active layer 23, and a second electrode plate 62 of a storage capacitor. The first active layer 21 may serve as an active layer of the first transistor T1, the second active layer 22 may serve as an active layer of the second transistor T2, the third active layer 23 may serve as an active layer of the third transistor T3, the second electrode plate 62 may serve as another transparent plate of the transparent storage capacitor, and the second electrode plate 62 is configured to form the transparent storage capacitor with the first electrode plate 61.

In an exemplary implementation, for the first sub-pixel P1 and the second sub-pixel P2, the first active layer 21 and the third active layer 23 may be provided on a side of the first electrode plate 61 of the current sub-pixel in the second direction Y, and the second active layer 22 may be provided on a side of the first electrode plate 61 of the current sub-pixel in a direction opposite to the second direction Y.

In an exemplary implementation, for the first sub-pixel P1, the first active layer 21 may be provided on a side of the corresponding sub-pixel away from the second sub-pixel P2, and the third active layer 23 may be provided on a side of the first sub-pixel P1 close to the second sub-pixel P2. For the second sub-pixel P2, the first active layer 21 may be provided on a side of the second sub-pixel P2 away from the first sub-pixel P1, and the third active layer 23 may be provided on a side of the second sub-pixel P2 close to the first sub-pixel P1.

In an exemplary implementation, for the third sub-pixel P3 and the fourth sub-pixel P4, the first active layer 21 and the third active layer 23 may be provided on a side of the first electrode plate 61 of the current sub-pixel in a direction opposite to the second direction Y, and the second active layer 22 may be provided on a side of the first electrode plate 61 of the current sub-pixel in the second direction Y.

In an exemplary implementation, for the third sub-pixel P3, the first active layer 21 may be provided on a side of the third sub-pixel P3 away from the fourth sub-pixel P4, and the third active layer 23 may be provided on a side of the third sub-pixel P3 close to the fourth sub-pixel P4. For the fourth sub-pixel P4, the first active layer 21 may be provided on a side of the fourth sub-pixel P4 away from the third sub-pixel P3, and the third active layer 23 may be provided on a side of the fourth sub-pixel P4 close to the third sub-pixel P3.

In an exemplary implementation, an active layer of each transistor may include a first region, a second region, and a channel region located between the first region and the second region.

In an exemplary implementation, an orthographic projection of a first region of the first active layer 21 of each sub-pixel on the base substrate is at least partially overlapped with an orthographic projection of a corresponding data signal line 52 on the base substrate, and a second region of the first active layer 21 is connected to the second electrode plate 62.

In an exemplary implementation, the second electrode plate 62 and the first active layer 21 of each sub-pixel may be interconnected to form an integral structure.

In an exemplary implementation, an orthographic projection of a first region of the second active layer 22 of each sub-pixel on the base substrate is at least partially overlapped with an orthographic projection of the power supply connection block 54 of the first power supply line 51 on the base substrate, and an orthographic projection of a second region and a channel region of the second active layer 22 on the base substrate is at least partially overlapped with the orthographic projection of the third connection electrode 13 on the base substrate, so that the first electrode plate 61 as a shield layer can shield the channel region of the second transistor T2, avoid influence of light on the channel, and ensure electrical performance of the second transistor T2.

In an exemplary implementation, an orthographic projection of a first region of the third active layer 23 of each sub-pixel on the base substrate is at least partially overlapped with an orthographic projection of a compensation signal line 53 on the base substrate, and an orthographic projection of a second region of the third active layer 23 on the base substrate is at least partially overlapped with an orthographic projection of the fourth connection electrode 14 of the current sub-pixel on the base substrate.

In an exemplary implementation, the first region of the third active layer 23 in the first sub-pixel P1 and the first region of the third active layer 23 in the second sub-pixel P2 may be connected to each other, and the first region of the third active layer 23 in the third sub-pixel P3 and the first region of the third active layer 23 in the fourth sub-pixel P4 may be connected to each other.

In an exemplary implementation, the third active layer 23 in the first sub-pixel P1 and the third active layer 23 in the second sub-pixel P2 may be of an integral structure connected to each other, and the third active layer 23 in the third sub-pixel P3 and the third active layer 23 in the fourth sub-pixel P4 may be of an integral structure connected to each other. In the present disclosure, the third active layers of two adjacent sub-pixels in one pixel row are arranged to be of an integral structure connected to each other, which not only saves space, but also reduces a via connection structure and simplifies a preparation process.

In an exemplary implementation, an orthographic projection of the third active layer 23 on the base substrate is at least partially overlapped with an orthographic projection of the first power supply line 51 on the base substrate.

In an exemplary implementation, the second electrode plate 62 may have a shape of a rectangle, corners of the rectangle may be chamfered, and the second electrode plate 62 may be disposed between the second active layer 22 and the third active layer 23 of the current sub-pixel. An orthographic projection of the second electrode plate 62 on the base substrate is at least partially overlapped with an orthographic projection of the first electrode plate 61 on the base substrate, the second electrode plate 62 may be a transparent intermediate electrode plate of a transparent storage capacitor, and the first electrode plate 61 and the second electrode plate 62 form the transparent first capacitor.

In an exemplary implementation, an area of a second electrode plate 62 in each sub-pixel may be substantially the same, so that a capacity of a storage capacitor in each sub-pixel is substantially the same.

In an exemplary implementation, the semiconductor layer may be made of a metal oxide such as an oxide containing indium and tin, an oxide containing tungsten and indium, an oxide containing tungsten, indium and zinc, an oxide containing titanium and indium, an oxide containing titanium, indium and tin, an oxide containing indium and zinc, an oxide containing silicon, indium and tin, an oxide containing indium, gallium and zinc, etc. The semiconductor layer may be a single layer, two layers, or a plurality of layers.

In an exemplary implementation, positions of respective patterns in the semiconductor layers in the first sub-pixel P1 and the third sub-pixel P3 may be substantially mirror-symmetrical with respect to the horizontal reference line, positions of respective patterns in the semiconductor layers in the second sub-pixel P2 and the fourth sub-pixel P4 may be substantially mirror-symmetrical with respect to the horizontal reference line, positions of respective patterns in the semiconductor layers in the first sub-pixel P1 and the second sub-pixel P2 may be substantially mirror-symmetrical with respect to the vertical reference line, and positions of respective patterns in the semiconductor layers in the third sub-pixel P3 and the fourth sub-pixel P4 may be substantially mirror-symmetrical with respect to the vertical reference line.

(14) A pattern of a second insulation layer is formed. In an exemplary implementation, forming the pattern of the second insulation layer may include: depositing a second insulation thin film on the base substrate on which the aforementioned patterns are formed, patterning the second insulation thin film through a patterning process to form the pattern of the second insulation layer that covers the semiconductor layer, wherein a plurality of vias are disposed on the second insulation layer, as shown in FIG. 8.

In an exemplary implementation, a plurality of vias of each sub-pixel in the display substrate include at least: a first via V1, a second via V2, a third via V3, a fourth via V4, a fifth via V5 and a sixth via V6.

In an exemplary implementation, an orthographic projection of the first via V1 on the base substrate is at least partially overlapped with the orthographic projection of the first region of the first active layer 21 on the base substrate, and an orthographic projection of the first via V1 on the base substrate is at least partially overlapped with the orthographic projection of the data signal line 52 on the base substrate. The first via V1 is a via of an transfer structure, which includes two half holes, the second insulation layer in a shallow half hole is etched away to expose a surface of the first region of the first active layer 21, and the first insulation layer and the second insulation layer in a deep half hole are etched away to expose a surface of the data signal line 52, so that the first via V1 of the transfer structure composed of the two half holes simultaneously exposes the first region of the first active layer 21 and the data signal line 52. The first via V1 is configured such that a data connection electrode to be formed subsequently is simultaneously connected with the first region of the first active layer 21 and the data signal line 52 through the via.

In an exemplary implementation, an orthographic projection of the second via V2 on the base substrate is at least partially overlapped with an orthographic projection of the first region of the second active layer 22 on the base substrate, and an orthographic projection of the second via V2 on the base substrate is at least partially overlapped with an orthographic projection of the power supply connection block 54 of the first power supply line 51 on the base substrate. The second via V2 is a via of an transfer structure, which includes two half holes, the second insulation layer in a shallow half hole is etched away to expose a surface of the first region of the second active layer 22, and the first insulation layer and the second insulation layer in a deep half hole are etched away to expose a surface of the power supply connection block 54, so that the second via V2 of the transfer structure composed of the two half holes simultaneously exposes the first region of the second active layer 22 and the power supply connection block 54. The second via V2 is configured such that a power supply connection electrode to be formed subsequently is simultaneously connected with the first region of the second active layer 22 and the power supply connection block 54 through the via.

In an exemplary implementation, an orthographic projection of the third via V3 on the base substrate is at least partially overlapped with the orthographic projection of the second region of the second active layer 22 on the base substrate, and an orthographic projection of the third via V3 on the base substrate is at least partially overlapped with the orthographic projection of the third connection electrode 13 on the base substrate. The third via V3 is a via of an transfer structure, which includes two half holes, the second insulation layer in a shallow half hole is etched away to expose a surface of the second region of the second active layer 22, and the first insulation layer and the second insulation layer in a deep half hole are etched away to expose a surface of the third connection electrode 13, so that the third via V3 of the transfer structure composed of the two half holes simultaneously exposes the second region of the second active layer 22 and the third connection electrode 13. The third via V3 is configured such that a fifth connection electrode to be formed subsequently is simultaneously connected with the second region of the second active layer 22 and the third connection electrode 13 through the via.

In an exemplary implementation, an orthographic projection of the fourth via V4 on the base substrate is at least partially overlapped with the orthographic projection of the first region of the third active layer 23 on the base substrate, and an orthographic projection of the fourth via V4 on the base substrate is at least partially overlapped with the orthographic projection of the compensation signal line 53 on the base substrate. The fourth via V4 is a via of an transfer structure, which includes two half holes, the second insulation layer in a shallow half hole is etched away to expose a surface of the first region of the third active layer 23, and the first insulation layer and the second insulation layer in a deep half hole are etched away to expose a surface of the compensation signal line 53, so that the fourth via V4 of the transfer structure composed of the two half holes simultaneously exposes the first region of the third active layer 23 and the compensation signal line 53. The fourth via V4 is configured such that a compensation connection electrode to be formed subsequently is simultaneously connected with the first region of the third active layer 23 and the compensation signal line 53 through the via.

In an exemplary implementation, since first regions of the third active layers in the first sub-pixel P1 and the second sub-pixel P2 are connected to each other, and first regions of the third active layers in the third sub-pixel P3 and the fourth sub-pixel P4 are connected to each other, the first sub-pixel P1 and the second sub-pixel P2 share the one fourth via V4, and the third sub-pixel P3 and the fourth sub-pixel P4 of the repeating unit share one fourth via V4.

In an exemplary implementation, an orthographic projection of the fifth via V5 on the base substrate is at least partially overlapped with the orthographic projection of the second region of the third active layer 23 on the base substrate, and an orthographic projection of the fifth via V5 on the base substrate is at least partially overlapped with the orthographic projection of the fourth connection electrode 14 on the base substrate. The fifth via V5 is a via of an transfer structure, which includes two half holes, the second insulation layer in a shallow half hole is etched away to expose a surface of the second region of the third active layer 23, and the first insulation layer and the second insulation layer in a deep half hole are etched away to expose a surface of the fourth connection electrode 14, so that the fifth via V5 of the transfer structure composed of the two half holes simultaneously exposes the second region of the third active layer 23 and the fourth connection electrode 14. The fifth via V5 is configured such that a sixth connection electrode to be formed subsequently is simultaneously connected with the second region of the third active layer 23 and the fourth connection electrode 14 through the via.

In an exemplary implementation, an orthographic projection of the sixth via V6 on the base substrate is located within a range of an orthographic projection of the second electrode plate 62 on the base substrate, the second insulation layer in the sixth via V6 is etched away to expose a surface of the second electrode plate 62, and the sixth via V6 is configured to connect the second gate electrode to be formed subsequently to the second electrode plate 62 through the sixth via V6.

In an exemplary implementation, in a process of forming the pattern of the second insulation layer, a plurality of vias are formed by a dry etching process, and a first conductorization treatment is performed on the semiconductor layer exposed by the vias, so that the semiconductor layer exposed by the vias forms a first conductorized region. During the first conductorization process, an edge portion of the semiconductor layer covered by the second insulation layer close to a via is also conductorized, i.e., the semiconductor layer after the first conductorization extends in a direction away from the vias.

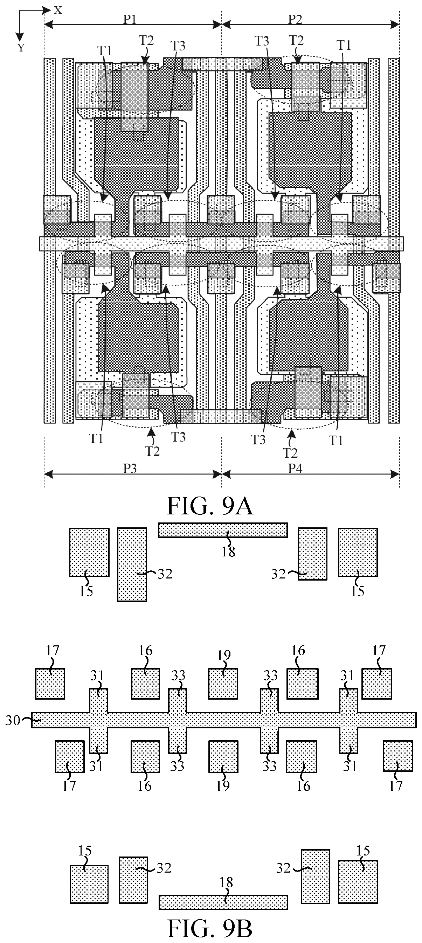

(15) A pattern of a third conductive layer is formed. In an exemplary implementation, forming the pattern of the third conductive layer may include: depositing a third conductive thin film on the base substrate on which the aforementioned patterns are formed, patterning the third conductive thin film through a patterning process to form the pattern of the third conductive layer on the second insulation layer, as shown in FIG. 9A and FIG. 9B, wherein FIG. 9B is a schematic diagram of the third conductive layer in FIG. 9A. In an exemplary implementation, the third conductive layer may be referred to as a gate metal (GT) layer.

In an exemplary implementation, the third conductive layer of each sub-pixel in the display substrate may at least include a fifth connection electrode 15, a sixth connection electrode 16, a data connection electrode 17, a power supply connection electrode 18, a compensation connection electrode 19, a scan signal line 30, a first gate electrode 31, a second gate electrode 32, and a third gate electrode 33.

In an exemplary implementation, the scan signal line 30 may have a shape of a line in which a main body portion extends along the first direction X, one scan signal line 30 may define two pixel rows, the scan signal line 30 is located between the first pixel row (including a first sub-pixel P1 and a second sub-pixel P2) and the second pixel row (a third sub-pixel P3 and a fourth sub-pixel P4), and the scan signal line 30 is configured to simultaneously control turn-on or turn-off of all the first transistors T1 and all the third transistors T3 in the four sub-pixels of the repeating unit.

In an exemplary implementation, the first gate electrode 31 may have a shape of a strip extending along the second direction Y, and may be provided on a side of the scan signal line 30 close to the first active layer 21. A first end of the first gate electrode 31 is connected to the scan signal line 30, a second end of the first gate electrode 31 extends in a direction towards the first active layer 21, and an orthographic projection of the first gate electrode 31 on the base substrate is at least partially overlapped with an orthographic projection of the first active layer 21 on the base substrate. In an exemplary implementation, the first gate electrode 31 may serve as a gate electrode of a first transistor T1, so that the scan signal line 30 may control turn-on or turn-off of the first transistor T1.

In an exemplary implementation, the second gate electrode 32 may have a shape of a strip extending along the second direction Y. A first end of the second gate electrode 32 is connected to the second electrode plate 62 through the sixth via V6, a second end of the second gate electrode 32 extends in a direction towards the second active layer 22, and an orthographic projection of the second gate electrode 32 on the base substrate is at least partially overlapped with an orthographic projection of the second active layer 22 on the base substrate. In an exemplary implementation, the second gate electrode 32 may serve as a gate electrode of a second transistor T2 and may control turn-on or turn-off of the second transistor T2.

In an exemplary implementation, since the second gate electrode 32 is connected to the second electrode plate 62 and the second electrode plate 62 is connected to the second region of the first active layer 21, it is achieved that the second electrode of the first transistor T1, the gate electrode of the second transistor T2 and the second electrode plate 62 (the first end of the storage capacitor) have a same potential, so that a first node in the pixel driving circuit is formed, and the second electrode plate 62 has a potential of the first node in the pixel driving circuit.

In an exemplary implementation, the third gate electrode 33 may have a shape of a strip extending along the second direction Y, and may be disposed on a side of the scan signal line 30 close to the third active layer 23. A first end of the third gate electrode 33 is connected with the scan signal line 30, a second end of the third gate electrode 33 extends along a direction towards the third active layer 23, and an orthographic projection of the third gate electrode 33 on the base substrate is at least partially overlapped with an orthographic projection of the third active layer 23 on the base substrate. In an exemplary implementation, the third gate electrode 33 may serve as a gate electrode of a third transistor T3, so that the scan signal line 30 may control turn-on or turn-off of the third transistor T3.

In an exemplary implementation, in one sub-pixel, one scan signal line 30 is simultaneously connected with the first gate electrode 31 and the third gate electrode 33, so that the scan signal line 30 may control turn-on or turn-off of a first transistor T1 and a third transistor T3 in one sub-pixel.

In an exemplary implementation, in one pixel row, one scan signal line 30 is simultaneously connected with all first gate electrodes 31 and all third transistors 33 in a plurality of sub-pixels, so that the scan signal line 30 may control turn-on or turn-off of all first transistors T1 and all third transistors T3 in one pixel row.

In an exemplary implementation, in one repeating unit, one scan signal line 30 is simultaneously connected with all first gate electrodes 31 and all third transistors 33 in a plurality of sub-pixels, so that the scan signal line 30 may simultaneously control turn-on or turn-off of all first transistors T1 and all third transistors T3 in the repeating unit.

In an exemplary implementation, within at least one repeating unit, the scan signal line 30, the first gate electrode 31 and the third gate electrode 33 may be of an integral structure connected to each other.

In an exemplary implementation, the fifth connection electrode 15 may have a shape of a block (for example, a rectangle), may be provided on a side of the second electrode plate 62 away from the scan signal line 30, and the fifth connection electrode 15 is simultaneously connected to the second region of the second active layer 22 and the third connection electrode 13 through the third via V3.

In an exemplary implementation, since the third connection electrode 13 is connected with the first connection electrode 11, and the first connection electrode 11 is connected with the first electrode plate 61, the fifth connection electrode 15 enables a second electrode of a second transistor and the first electrode plate 61 to have a same potential. In an exemplary implementation, the fifth connection electrode 15 is configured to be connected with a tenth connection electrode to be formed subsequently.

In an exemplary implementation, the sixth connection electrode 16 may have a shape of a block (for example, a rectangle) and may be provided on a side of the second electrode plate 62 close to the scan signal line 30, and the sixth connection electrode 16 is simultaneously connected to the second region of the third active layer 23 and the fourth connection electrode 14 through the fifth via V5.

In an exemplary implementation, since the fourth connection electrode 14 is connected with the second connection electrode 12, and the second connection electrode 12 is connected with the first electrode plate 61, the sixth connection electrode 16 enables a second electrode of a third transistor and the first electrode plate 61 to have a same potential.

In an exemplary implementation, connection between the second electrode of the second transistor, the second electrode of the third transistor, and the first electrode plate 61 (the second end of the storage capacitor) is achieved by the fifth connection electrode 15 and the sixth connection electrode 16, and a second node in the pixel driving circuit is formed, so that the first electrode plate 61 has a potential of the second node in the pixel driving circuit.

In an exemplary implementation, since the first electrode plate 61 has the potential of the second node in the pixel driving circuit and the second electrode plate 62 has the potential of the first node in the pixel driving circuit, the first electrode plate 61 with the potential of the second node and the second electrode plate 62 with the potential of the first node form a storage capacitor.

In an exemplary implementation, since the first electrode plate 61 is made of a transparent conductive material and the second electrode plate 62 is made of a transparent metal oxide, the storage capacitor is a transparent capacitor.

In an exemplary implementation, the data connection electrode 17 may have a shape of a block (for example, a rectangle), and the data connection electrode 17 is simultaneously connected to the first region of the first active layer 21 and the data signal line 52 through the first via V1, thereby achieving that a data signal is written to the first electrode of the first transistor T1 by the data signal line 52. In an exemplary implementation, each data signal line 52 may be connected with a first region of a first active layer in one sub-pixel through the first via V1, thereby achieving that data signals are written into first electrodes of four first transistors T1 in one repeating unit by four data signal lines 52, respectively.

In an exemplary implementation, the four data signal lines 52 may include the first data signal line 52-1, the second data signal line 52-2, the third data signal line 52-3, and the fourth data signal line 52-4 sequentially arranged along the first direction X. The first data signal line 52-1 may be located on a side of the first pixel column in a direction opposite to the first direction X, and may be connected with a first region of a first active layer in a first sub-pixel P1 through the data connection electrode 17. The second data signal line 52-2 may be located on a side of the first data signal line in the first direction X, and may be connected with a first region of a first active layer in a third sub-pixel P3 through the data connection electrode 17. The fourth data signal line 52-4 may be located on a side of a second pixel column in the first direction X, and may be connected with a first region of a first active layer in a fourth sub-pixel P4 through the data connection electrode 17. The third data signal line 52-3 may be located on a side of the fourth data signal line 52-4 in a direction opposite to the first direction X, and may be connected with a first region of a first active layer in a second sub-pixel P2 through the data connection electrode 17.

In the exemplary implementation, the power supply connection electrode 18 may have a strip shape extending along the first direction X and may be arranged on a side of the second electrode plate 62 away from the scan signal line 30, and the power supply connection electrode 18 may be simultaneously connected to a first region of the second active layer 22 and the power supply connection block 54 through the second via V2. Since the power supply connection electrode 54 is connected to the power supply connection line 51, writing of the first power supply signal into the first electrode of the second transistor T2 by the first power supply line 51 is achieved.

In an exemplary implementation, the two first power supply lines 51 may include the first one of first power supply lines 51-1 and the second one of first power supply lines 51-2 sequentially arranged along the first direction X. The first one of first power supply lines 51-1 may be located in the first pixel column on a side of the compensation signal line 54 in a direction opposite to the first direction X, and may be connected to the first regions of the second active layers 22 in the first sub-pixel P1 and the third sub-pixel P3 through two power supply connection electrodes 18 in the first pixel column, respectively. The second one of first power supply lines 51-2 may be located in the second pixel column on a side of the compensation signal line 54 in the first direction X, and may be connected to the first regions of the second active layers 22 in the second sub-pixel P2 and the fourth sub-pixel P4 through two power supply connection electrodes 18 in the second pixel column, respectively.

In an exemplary implementation, a first power supply line 51 of a first pixel column may simultaneously supply a first power supply signal to pixel driving circuits in a first sub-pixel P1 and a third sub-pixel P3, and a first power supply line 51 of a second pixel column may simultaneously supply a first power supply signal to pixel driving circuits in a second sub-pixel P2 and a fourth sub-pixel P4, therefore a first power supply line 51 in one repeating unit has a one-drag-two structure. In the display substrate according to the present disclosure, a first power supply line is designed to have a one-drag-two structure, which saves a quantity of signal lines, reduces occupied space, has a simple structure and a reasonable layout, makes full use of layout space, improves a space utilization rate, and is beneficial to improving a resolution.

In an exemplary implementation, two first power supply lines 51 in one repeating unit are symmetrically disposed with respect to a compensation signal line 53, and a second transistor T2 of the first pixel column and a second transistor T2 of the second pixel column are symmetrically disposed with respect to the compensation signal line 53. This symmetrical structure according to the present disclosure may ensure that a voltage drop of a first power supply line written into a second transistor T2 is substantially the same, ensuring display uniformity.

In an exemplary implementation, the power connection electrodes 18 in the first sub-pixel P1 and the second sub-pixel P2 may be connected to each other, and the power connection electrodes 18 in the third sub-pixel P3 and the fourth sub-pixel P4 may be connected to each other.

In an exemplary implementation, the power supply connection electrodes 18 in the first sub-pixel P1 and the second sub-pixel P2 may be of an integral structure connected to each other, that is, the first sub-pixel P1 and the second sub-pixel P2 share one power supply connection electrode 18. The power supply connection electrodes 18 in the third sub-pixel P3 and the fourth sub-pixel P4 may be of an integrated structure connected to each other, that is, the third sub-pixel P3 and the fourth sub-pixel P4 share one power supply connection electrode 18.

In the exemplary implementation, the power supply connection electrode 18 may be used as a transverse power supply connection line. The power supply connection electrode of the integral structure has a strip shape extending along the first direction X, and is provided across the first pixel column and the second pixel column, such that the first sub-pixel P1 and the second sub-pixel P2 share one power supply connection electrode 18, and the third sub-pixel P3 and the fourth sub-pixel P4 share one power supply connection electrode 18. Since the two first voltage lines 51 can simultaneously provide a first voltage signal to the pixel driving circuits in the four sub-pixels, the four pixel driving circuits in a repeating unit can share two first voltage lines 51.

In an exemplary implementation, an orthographic projection of the power supply connection electrode on the base substrate is not overlapped with an orthographic projection of the data signal line 52 on the base substrate, and an orthographic projection of the power supply connection electrode 18 on the base substrate is at least partially overlapped with an orthographic projection of the compensation signal line 53 on the base substrate.

In an exemplary implementation, the compensation connection electrode 19 may have a shape of a block (for example, a rectangle), may be provided between the third gate electrodes 33 of two adjacent sub-pixels in the first direction X, and may be simultaneously connected to the first region of the third active layer 23 and the compensation signal line 53 through the fourth via V4, thereby achieving that a compensation signal is written to the first electrode of the third transistor T3 by the compensation signal line 53.

In an exemplary implementation, since the first regions of the third active layers in the first sub-pixel P1 and the second sub-pixel P2 are connected to each other, and the first sub-pixel P1 and the second sub-pixel P2 share one fourth via V4, the first sub-pixel P1 and the second sub-pixel P2 share one eighth compensation electrode 19. Since the first regions of the third active layers in the third sub-pixel P3 and the fourth sub-pixel P4 are connected to each other, and the third sub-pixel P3 and the fourth sub-pixel P4 share one fourth via V4, the third sub-pixel P3 and the fourth sub-pixel P4 share one eighth compensation electrode 19.

In an exemplary implementation, the compensation signal line 53 may simultaneously supply a compensation signal to pixel driving circuits in four sub-pixels so that four pixel driving circuits in one repeating unit may share one compensation signal line 53, i.e., the compensation signal line 53 in one repeating unit has a one-drag-four structure. In the display substrate according to the present disclosure, a compensation signal line is designed to have a one-drag-four structure, which saves a quantity of signal lines, reduces occupied space, has a simple structure and a reasonable layout, makes full use of layout space, improves a space utilization rate, and is beneficial to improving a resolution.

In an exemplary implementation, the compensation signal line 53 is disposed between the first pixel column and the second pixel column, and a third transistor T3 of the first pixel column and a third transistor T3 of the second pixel column are symmetrically disposed with respect to the compensation signal line 53. This symmetrical structure according to the present disclosure may ensure that a Resistor-Capacitor (RC) delay of a compensation signal written into a third transistor T3 is substantially the same, ensuring display uniformity.

In an exemplary implementation, positions of respective patterns in the third conductive layers in the first sub-pixel P1 and the third sub-pixel P3 may be substantially mirror-symmetrical with respect to the horizontal reference line, positions of respective patterns in the third conductive layers in the second sub-pixel P2 and the fourth sub-pixel P4 may be substantially mirror-symmetrical with respect to the horizontal reference line, positions of respective patterns in the third conductive layers in the first sub-pixel P1 and the second sub-pixel P2 may be substantially mirror-symmetrical with respect to the vertical reference line, and positions of respective patterns in the third conductive layers in the third sub-pixel P3 and the fourth sub-pixel P4 may be substantially mirror-symmetrical with respect to the vertical reference line.

In an exemplary implementation, in a process of forming the pattern of the third conductive layer, a wet etching process is first adopted to form the pattern of the third conductive layer, so that at least one connection electrode is simultaneously connected with the second conductive layer and the semiconductor layer through a via of an transfer structure. The via of the transfer structure may at least include two half holes: a shallow half hole and a deep half hole. The second insulation layer in the shallow half hole is removed to expose a surface of the semiconductor layer, the second insulation layer and the first insulation layer in the deep half hole are removed to expose a surface of the second conductive layer, thereby achieving that the connection electrode is simultaneously connected to the semiconductor layer and the second conductive layer by the shallow half hole and the deep half hole. In an exemplary implementation, a distance is provided between an end of the connection electrode and an edge of the shallow half hole in an area of the shallow half hole, i.e., the connection electrode does not fully cover the shallow half hole.

In an exemplary implementation, after forming the pattern of the third conductive layer by the wet etching process, the second insulation layer in an area other than the third conductive layer is etched by a dry etching process in a self-alignment process using the third conductive layer as a mask, and a second conductorization is performed on the exposed semiconductor layer while the second insulation layer is etched away, forming a second conductorized region.

In an exemplary implementation, during a second conductorization process, an edge portion of the semiconductor layer covered by the third conductive layer is also conductorized, i.e., the semiconductor layer after the second conductorization extends to a first conductorized region, and a twice conductorized region is formed in an overlapping region of the first conductorized region and a second conductorized region, so that a reliable connection between the third conductive layer and the semiconductor layer may be ensured.

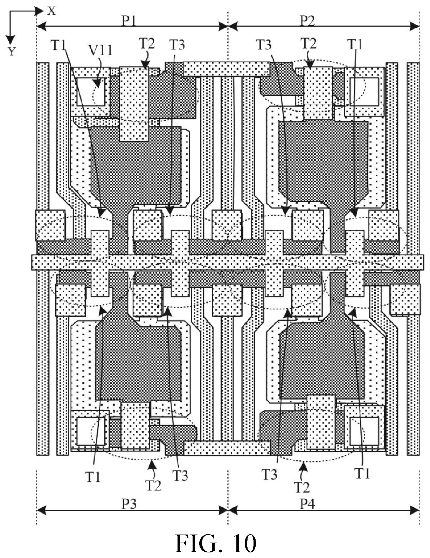

(16) Patterns of a third insulation layer and a planarization layer are formed. In an exemplary implementation, forming the patterns of the third insulation layer and the planarization layer may include first depositing a third insulation thin film on the base substrate on which the aforementioned patterns are formed, then coating a planarization thin film, and patterning the planarization thin film and the third insulation thin film by a patterning process to form the third insulation layer that covers the third conductive layer and the pattern of the planarization layer provided on the third insulation layer, and the planarization layer is provided with a plurality of vias, as shown in FIG. 10.

In an exemplary implementation, a via of each sub-pixel at least includes an eleventh via V11.

In an exemplary implementation, an orthographic projection of the eleventh via V11 on the base substrate is located within a range of an orthographic projection of the fifth connection electrode 15 on the base substrate. The third insulation layer and the planarization layer in the eleventh via V11 are etched away to expose a surface of the fifth connection electrode 15, and the eleventh via V11 is configured such that a tenth connection electrode to be formed subsequently is connected with the fifth connection electrode 15 through the via.

In an exemplary implementation, this process may adopt a one-time patterning process to simultaneously form vias on the third insulation layer and the planarization layer, and a MASK plate (MASK) process in which the third insulation layer and the planarization layer share one-time halftone or gray tone, which effectively reduces times of patterning processes.

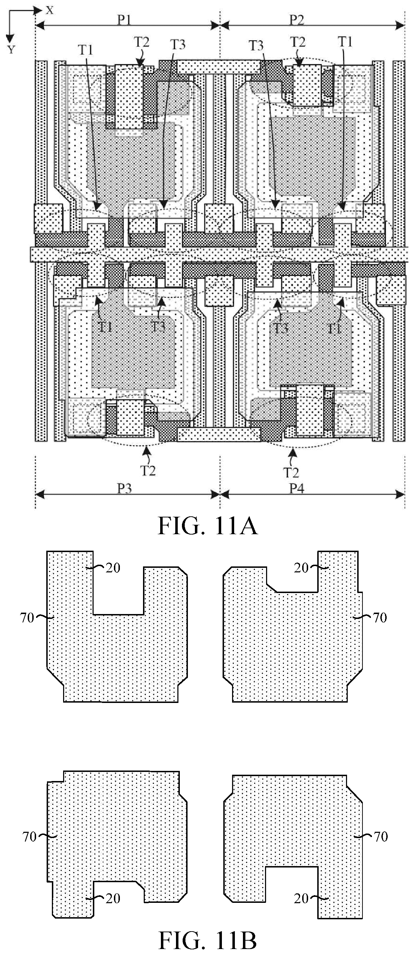

(17) A pattern of a fourth conductive layer is formed. In an exemplary implementation, forming the pattern of the fourth conductive layer may include: depositing a fourth conductive thin film on the base substrate on which the aforementioned patterns are formed, and patterning the fourth conductive thin film through a patterning process to form the pattern of the fourth conductive layer on the first planarization layer, as shown in FIG. 11A and FIG. 11B, FIG. 11B is a schematic diagram of the fourth conductive layer in FIG. 11A.

In an exemplary implementation, the fourth conductive layer of each sub-pixel in the display substrate may at least include a tenth connection electrode 20, and a first connection electrode 70, which may be an anode.

In an exemplary implementation, the first electrode 70 may have a shape of a rectangle, corners of the rectangle may be provided with chamfers, grooves or protrusions, and an orthographic projection of the first electrode 70 on the base substrate is at least partially overlapped with an orthographic projection of the second electrode plate 62 on the base substrate.

In an exemplary implementation, the tenth connection electrode 20 may have a shape of a block (for example, a rectangle), may be on a side of the first electrode 70 away from the scan signal line 30, a first end of the tenth connection electrode 20 is connected to the first electrode 70, a second end of the tenth connection electrode 20 extends in a direction away from the scan signal line 30, and is connected to the fifth connection electrode 15 through the eleventh via V11.

In an exemplary implementation, in at least one sub-pixel, the tenth connection electrode 20 and the first electrode 70 may be interconnected to form an integral structure.

In an exemplary implementation, four first electrodes 70 in one repeating unit are arranged in a square, an upper left anode is connected with a pixel driving circuit in a first sub-pixel P1, an upper right anode is connected with a pixel driving circuit in a second sub-pixel P2, a lower left anode is connected with a pixel driving circuit in a third sub-pixel P3, and a lower right anode is connected with a pixel driving circuit in a fourth sub-pixel P4. In some possible Implementations, an arrangement mode of the anodes may be adjusted according to actual needs, which is not specifically limited herein in the present disclosure.

In an exemplary implementation, the first conductive layer may be made of a transparent conductive material, such as Indium Tin Oxide (ITO) or Indium Zinc Oxide (IZO).

In an exemplary implementation, positions of respective patterns in the fourth conductive layers in the first sub-pixel P1 and the third sub-pixel P3 may be substantially mirror-symmetrical with respect to the horizontal reference line, positions of respective patterns in the fourth conductive layers in the second sub-pixel P2 and the fourth sub-pixel P4 may be substantially mirror-symmetrical with respect to the horizontal reference line, positions of respective patterns in the fourth conductive layers in the first sub-pixel P1 and the second sub-pixel P2 may be substantially mirror-symmetrical with respect to the vertical reference line, and positions of respective patterns in the fourth conductive layers in the third sub-pixel P3 and the fourth sub-pixel P4 may be substantially mirror-symmetrical with respect to the vertical reference line.

In an exemplary implementation, the first electrode 70 may also serve as an auxiliary capacitor for the storage capacitor. Since the first electrode 70 is connected to the tenth connection electrode 20, the tenth connection electrode 20 is connected to the first electrode 61 through the fifth connection electrode 15, the third connection electrode 13, and the first connection electrode 11, the first electrode 70 has a potential of the second node in the pixel driving circuit, so that the first electrode 70 with the potential of the second node and the second electrode plate 62 with a potential of the first node form the auxiliary capacitor, and the auxiliary capacitor and the storage capacitor are connected in parallel. In the present disclosure, the anode is used to form the auxiliary capacitor, and the auxiliary capacitor and the storage capacitor are connected in parallel, so that on one hand, a capacitance value of the storage capacitor can be effectively increased, on the other hand, an area of an electrode plate can be reduced under a condition of ensuring the capacitance value of the storage capacitor, and an occupied area can be effectively reduced.

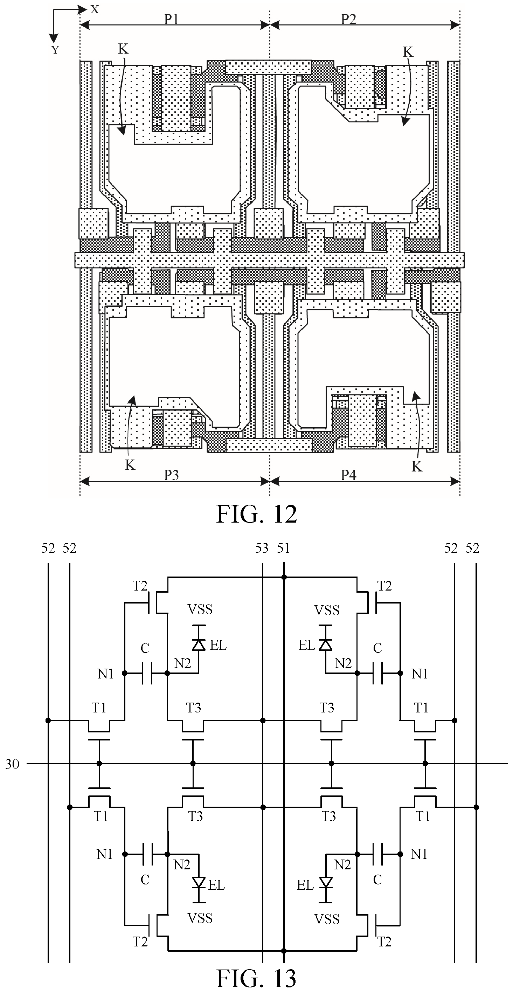

(18) A pixel definition layer is formed. In an exemplary implementation, forming the pattern of the pixel definition layer may include coating a pixel definition thin film on the base substrate on which the aforementioned patterns are formed, and patterning the pixel definition thin film by a patterning process to form the pixel definition layer that covers the fourth conductive layer, as shown in FIG. 12.

In an exemplary implementation, a pixel opening K is formed on the pixel definition layer of each sub-pixel in the display substrate, the pixel definition thin film in the pixel opening K is removed to expose a part of surface of the first electrode plate 70, and an orthographic projection of the pixel opening K on the base substrate is located within a range of an orthographic projection of the first electrode plate 70 on the base substrate.

In an exemplary implementation, a shape of the pixel opening K may be similar to a shape of the first electrode 70 on a plane parallel to the base substrate, and a shape of a cross-section of the pixel opening K may be rectangular, trapezoidal or the like on a plane perpendicular to the base substrate.

In an exemplary implementation, a shape of a pixel opening may include any one or more of following: a triangle, a rectangle, a trapezoid, a parallelogram, a five-frame shape, a six-frame shape, a circle, and an ellipse.

In an exemplary implementation, shapes of pixel openings of four sub-pixels may be the same or may be different. Areas of the pixel openings of the four sub-pixels may be the same or may be different.

In an exemplary implementation, shapes and areas of pixel openings of four sub-pixels may be different to accommodate transmittances of filters of different sub-pixels, so that light emitting devices of the four sub-pixels may emit light with same brightness at different currents, service lives of light emitting devices of the four sub-pixels are optimized to a maximum extent, and a product life is guaranteed.

In the exemplary implementation, at least one partition groove may be provided on the pixel definition layer of each repeating unit in the display substrate. The partition groove M may have a strip shape in which a main body portion extends along the first direction X or the second direction Y, and may be provided between adjacent sub-pixels in the first direction X or the second direction Y. The partition groove M is configured to truncate an organic light emitting layer formed subsequently, block a lateral propagation path of the hole-type carriers, eliminate lateral leakage, and eliminate lateral crosstalk of sub-pixels.

In an exemplary implementation, the pixel definition layer may be made of polyimide, acrylic, or polyethylene terephthalate, etc.

(19) Patterns of an organic emitting layer and a cathode are formed. In an exemplary implementation, forming the patterns of the organic emitting layer and the cathode may include: forming a pattern of an organic emitting layer, wherein the organic emitting layer is connected with the first electrode 70 through the pixel opening K. A cathode is formed subsequently, and the cathode is connected with the organic emitting layer.

In an exemplary implementation, the organic emitting layer may include an Emitting Layer (EML) and any one or more of following: a Hole Injection Layer (HIL), a Hole Transport Layer (HTL), an Electron Block Layer (EBL), a Hole Block Layer (HBL), an Electron Transport Layer (ETL), and an Electron Injection Layer (EIL). In an exemplary implementation, the organic emitting layer may be formed through evaporation using a Fine Metal Mask (FMM) or an Open Mask, or through an inkjet process.

(20) A pattern of an encapsulation structure layer is formed. In an exemplary implementation, forming the pattern of the encapsulation structure layer may include: depositing a first inorganic thin film using an open mask, so as to form a first encapsulation layer. Then, inkjet printing an organic material is performed on the first encapsulation layer by using an inkjet printing process, and a second encapsulation layer is formed after curing. then, depositing a second inorganic thin film by using an open mask to form a third encapsulation layer, wherein the first encapsulation layer, the second encapsulation layer and the third encapsulation layer form the encapsulation structure layer. The first encapsulation layer and the third encapsulation layer may be made of any one or more of Silicon Oxide (SiOx), Silicon Nitride (SiNx), Silicon Carbide (SiC), Silicon Carbonitride (SiCN), and Silicon Oxynitride (SiON), and may be a single layer, a multi-layer, or a composite layer. The second encapsulation layer may be made of a resin material, thereby forming a stacked structure of an inorganic material/an organic material/an inorganic material, wherein an organic material layer is disposed between two inorganic material layers, thus ensuring that external water vapor cannot enter a light emitting structure layer.

So far, the preparation of the display substrate according to an exemplary implementation of the present disclosure is completed. The display substrate may include a drive circuit layer provided on the base substrate, a light emitting structure layer provided on a side of the drive circuit layer away from the base substrate, and an encapsulation structure layer provided on a side of the light emitting structure layer away from the base substrate. In a direction perpendicular to the base substrate, the drive circuit layer may include a first conductive layer, a second conductive layer, a first insulation layer, a semiconductor layer, a second insulation layer, a third conductive layer, a third insulation layer and a planarization layer provided sequentially on the base substrate, the light emitting structure layer may include an anode, a pixel definition layer, an organic emitting layer and a cathode, and the encapsulation structure layer may include a first encapsulation layer, a second encapsulation layer and a third encapsulation layer that are stacked.

In an exemplary implementation, for a display substrate including a color filter structure layer, after the third conductive layer is formed, a third insulation layer may be formed first, then a red color filter layer, a green color filter layer, and a blue color filter layer may be sequentially formed, and then a planarization layer may be formed, which is not limited here in the present disclosure.

In an exemplary implementation, the base substrate may be a flexible substrate, or a rigid substrate. The rigid base substrate may be made of, but is not limited to, one or more of glass and quartz. The flexible base substrate may be made of, but is not limited to, one or more of polyethylene terephthalate, ethylene terephthalate, polyether ether ketone, polystyrene, polycarbonate, polyarylate, polyarylester, polyimide, polyvinyl chloride, polyethylene, and textile fiber. In an exemplary implementation, the flexible substrate may include a first flexible material layer, a first inorganic material layer, a semiconductor layer, a second flexible material layer, and a second inorganic material layer which are stacked, wherein materials of the first flexible material layer and the second flexible material layer may be Polyimide (PI), Polyethylene Terephthalate (PET), or a surface-treated polymer soft film, or the like, materials of the first inorganic material layer and the second inorganic material layer may be Silicon Nitride (SiNx) or Silicon Oxide (SiOx), or the like, for improving a water and oxygen resistance capability of the base substrate, and a material of the semiconductor layer may be amorphous silicon (a-si).

In an exemplary implementation, the second conductive layer and the third conductive layer may be made of a metal material, such as any one or more of Argentum (Ag), Copper (Cu), Aluminum (Al), and Molybdenum (Mo), or an alloy material of the above metals, such as an Aluminum Neodymium alloy (AlNd) or a Molybdenum Niobium alloy (MoNb), and may be of a single-layer structure or a multi-layer composite structure, such as Mo/Cu/Mo. The first insulation layer, the second insulation layer, and the second insulation layer may be made of any one or more of Silicon Oxide (SiOx), Silicon Nitride (SiNx), and Silicon Oxynitride (SiON), and may be a single layer, a multi-layer, or a composite layer. The planarization layer may be made of an organic material such as resin.

At present, the existing display apparatus has problems such as low aperture ratio and pixel light leakage. After a research of the inventor of the present application, it is found that the above-mentioned problems are caused by the unreasonable arrangement of signal wires. According to an arrangement mode of one compensation signal line, two first power supply lines and four data signal lines in one repeating unit in the existing display apparatus, the compensation signal line is arranged between the first pixel column and the second pixel column, two data signal lines are arranged on a side of the first pixel column away from the compensation signal line, one first power supply line is arranged on a side of the two data signal lines away from the compensation signal line, the other two data signal lines are arranged on a side of the second pixel column away from the compensation signal line, the other one first power supply line is arranged on a side of the two data signal lines away from the compensation signal line, and the pixel driving circuit is arranged between the data signal line and the compensation signal line. Since only one compensation signal line is provided between the first pixel column and the second pixel column, a distance between the first sub-pixel and the third sub-pixel in the first pixel column and the second sub-pixel and the fourth sub-pixel in the second pixel column is made to be relatively close, which not only easily loses the pixel opening, resulting in a reduction of the opening ratio, but also increases a risk of pixel light leakage, resulting in a pixel light leakage problem. Further, for the adjacent first repeating unit and the second repeating unit in the first direction, since five signal lines (two data signal lines for each pixel column and a first power supply line shared by the two pixel columns) are provided between the second pixel column in the first repeating unit and the first pixel column in the second repeating unit, a distance between the second sub-pixel and the fourth sub-pixel of the second pixel column in the first repeating unit, and the first sub-pixel and the third sub-pixel of the first pixel column in the second repeating unit is made to be relatively long, which relatively wastes space.

The embodiment of the present disclosure provides a display substrate with a bottom emission structure. By adjusting an arrangement mode of signal lines, an aperture ratio can be effectively increased and the risk of pixel light leakage can be reduced. According to an arrangement mode of one compensation signal line, two first power supply lines and four data signal lines in a repeating unit in the present disclosure, the compensation signal line are provided in the middle of the repeating unit (between the first pixel column and the second pixel column) in the first direction, the first one of first power supply lines is provided on a side of the first pixel column close to the compensation signal line, the second one of first power supply lines is provided on a side of the second pixel column close to the compensation signal line, two data signal lines are arranged on a side of the first pixel column away from the compensation signal line, and the other two data signal lines are arranged on a side of the second pixel column away from the compensation signal line. An arrangement order of the signal lines are changed into: the first data signal line, the second data signal line, the first one of first power supply lines, the compensation signal line, the second one of first power supply lines, the third data signal line and the fourth data signal line, and the pixel driving circuit of the first pixel column is arranged between the second data signal line and the first one of first power supply lines. A pixel driving circuit of the second pixel column is arranged between the second one of first power supply lines and the third data signal line. In the present disclosure, the first power supply line and the compensation signal line are arranged in the middle of the repeating unit, and the data signal line is arranged on both sides of the repeating unit, which effectively balances a distance distribution of the opaque metal signal lines between sub-pixels. Since a compensation signal line and two first power supply lines are provided between the first pixel column and the second pixel column, a distance between the sub-pixels in the first pixel column and the sub-pixels in the second pixel column is increased, which not only avoids the loss of pixel opening, effectively increases the aperture ratio, but also reduces the risk of pixel light leakage, and can effectively eliminate pixel light leakage. In addition, since four signal lines (two data signal lines for each pixel column) are provided between the second pixel column in the first repeating unit and the first pixel column in the second repeating unit, a distance between the sub-pixels in the first repeating unit and the sub-pixels in the second repeating unit is reduced, which relatively saves the space, and is beneficial to improving the resolution.

In the existing display apparatus, since the first power supply line in each pixel column is arranged on a side of the two data signal lines away from the compensation signal line, a power supply connection line extending along the first direction X (lateral) is arranged in each pixel column to achieve a connection between the first power supply line and the second transistor, and an orthographic projection of the power supply connection line on the base substrate is overlapped with an orthographic projection of the two data signal lines on the base substrate. That is, the power supply connection line in the existing structure is cross-line overlapped with all four data signal lines.

In an embodiment of the present disclosure, the first power supply line is arranged on a side of the pixel column close to the compensation signal line, and the data signal line is arranged on a side of the pixel column away from the compensation signal line, such that an orthographic projection of the power supply connection electrode as the transverse power supply connection line on the base substrate is not overlapped with an orthographic projection of the data signal line on the base substrate. That is, the power supply connection electrode in an embodiment of the present disclosure is not cross-line overlapped with all four data signal lines, but only is cross-line overlapped with one compensation signal line. In an embodiment of the present disclosure, the cross-line structures are reduced, which can effectively improve the process accuracy and the product yield rate.

In an embodiment of the present disclosure, two power supply connection electrodes are arranged in the repeating unit, which are respectively connected with two first power supply lines, so as to form an annular structure for transmitting the first power supply signal in the repeating unit, which is beneficial to improving the product yield rate. For example, when there is a short circuit defect at a position where the power supply connection electrode crosses the compensation signal line, the short circuit defect can be repaired by truncating one power supply connection electrode to improve the product yield. For another example, when there is a short circuit defect at a position where the third active layer crosses the first power supply line, the short circuit defect can be repaired by truncating one first power supply line to improve the product yield rate.

In an embodiment of the present disclosure, two first power supply lines are arranged on both sides of the compensation signal line, and the first power supply line with a constant potential can effectively shield the influence of the jump signal in the pixel driving circuit on the compensation signal line, thereby improving the accuracy of external compensation, and improving the display effect and display quality.

According to an embodiment of the present disclosure, the first power supply line, the data signal line, and the compensation signal line are arranged on the SHIELD layer and located on a side of the semiconductor layer close to the base substrate, and the scan signal line and gate electrodes of a plurality of transistors are arranged on the GT layer and located on a side of the semiconductor layer away from the base substrate, which not only reduces one conductive layer, but also reduces a patterning process of transfer vias and a patterning process of switch conductive layer, so that a preparation process of the drive structure layer requires only six patterning processes, thereby reducing times of patterning processes, effectively improving a production efficiency, effectively reducing a production cost, and maximizing a product yield rate.

According to an embodiment of the present disclosure, the 3T1C pixel driving circuit using one scan signal line is adopted, in which the scan signal line is connected to a first transistor and a third transistor in the pixel driving circuit. By reducing a quantity of scan signal lines, a structure of the pixel driving circuit can be simplified, an area occupied by the pixel driving circuit can be reduced, and high-resolution display can be achieved. In addition, since one repeating unit only needs to be driven by one scan signal line, a quantity of corresponding gate drive circuits (GOA) and clock signal lines (CLK) may be reduced by a plurality of times, areas occupied by the gate drive circuits and clock signal lines are effectively reduced, which is beneficial to achieving a narrow bezel, and improving product advantages.

According to an exemplary embodiment of the present disclosure, a transparent storage capacitor is composed of a transparent conductive layer and a transparent semiconductor layer, so that light may be emitted through the transparent storage capacitor, thus the storage capacitor may be disposed in a pixel opening, and not only a capacitance amount of the storage capacitor may be effectively increased, but also a pixel aperture ratio may be effectively increased.

The pixels according to an embodiment of the present disclosure adopt a square arrangement of sub-pixels and adopt a structure of first power supply lines with a non-mesh structure, the pixel aperture ratio is effectively increased, and a display effect is improved, which is more suitable for displaying of the display type.

The preparation process in the present disclosure may be compatible well with an existing preparation process, is simple in process implementation, is easy to implement, and has a high production efficiency, a low production cost, and a high yield.

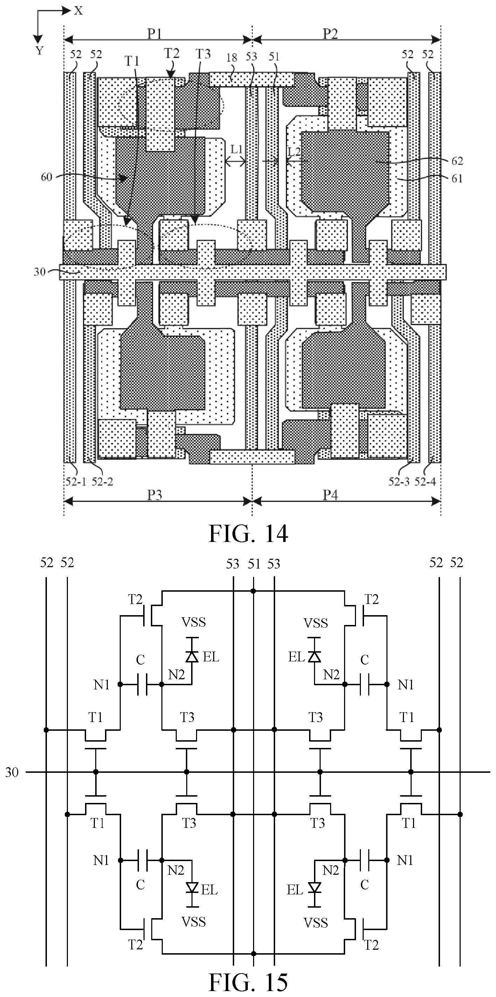

FIG. 13 is an equivalent circuit diagram of a pixel driving circuit in another repeating unit according to an exemplary embodiment of the present disclosure, and FIG. 14 is a schematic diagram of a structure of another display substrate according to an exemplary embodiment of the present disclosure. As shown in FIGS. 13 and 14, the pixel driving circuit and the main structure of the display substrate of the present embodiment are substantially the same as those of the embodiments shown in FIGS. 3 and 4, except that one repeating unit in the present embodiment is provided with a first power supply line 51.

In an exemplary implementation, at least one repeating unit may include one scan signal line 30, one first power supply line 51, four data signal lines 52, and one compensation signal line 53. The shapes, positions, and connection relationships with the pixel driving circuit, of the scan signal line 30, the data signal lines 52 and the compensation signal line 53 may be substantially the same as in the foregoing embodiment. The pixel driving circuit of at least one sub-pixel may include a first transistor T1, a second transistor T2, a third transistor T3, and a storage capacitor 60, which may at least include a first electrode 61 and a second electrode 62 as electrode plates of the capacitor, and the related connection structure is substantially the same as the foregoing embodiment, which will not be repeated here.

In an exemplary implementation, the first power supply line 51 may be provided on a side of the compensation signal line 53 in the first direction X, that is, the first power supply line 51 is provided on a side of the second pixel column close to the compensation signal line 53. In another exemplary implementation, the first power supply line 51 may be provided on a side of the compensation signal line 53 in a direction opposite to the first direction X , that is, the first power supply line 51 is provided on a side of the first pixel column close to the compensation signal line 53.

In the exemplary implementation, the power supply connection electrode 18 may have a stripe shape extending along the first direction X, the power supply connection electrode 18 in the first sub-pixel P1 and the second sub-pixel P2 may be of an integral structure connected to each other, and the power supply connection electrodes 18 in the third sub-pixel P3 and the fourth sub-pixel P4 may be of an integral structure connected to each other.

In an exemplary implementation, the first power supply line 51 is provided in the second pixel column as an example. A first end of the power supply connection electrode 18 is connected to a first region of the second active layer 22 in the first pixel column through the second via V2 in the first pixel column, and a second end of the power supply connection electrode 18 is simultaneously connected to a first region of the second active layer 22 and the first power supply line 51 in the second pixel column through the second via V2 in the second pixel column after extending to the second pixel column along the first direction X, thus achieving that the first power supply line 51 writes the first power supply signal to the first electrodes of the four second transistors T2 in the two pixel columns.

In an exemplary implementation, one first power supply line 51 may simultaneously provide a first power supply signal to the pixel driving circuits in the four sub-pixels, so that the first power supply line 51 in one repeating unit has a one-drag-four structure. In the display substrate according to the present disclosure, a first power supply line is designed to have a one-drag-four structure, which saves a quantity of signal lines, reduces occupied space, has a simple structure and a reasonable layout, makes full use of layout space, improves a space utilization rate, and is beneficial to improving a resolution and transparency.

In the exemplary embodiment, the power supply connection electrode 18 may serve as a transverse power supply connection line, an orthographic projection of the power supply connection electrode 18 on the base substrate is not overlapped with an orthographic projection of the data signal line 52 on the base substrate, and an orthographic projection of the power supply connection electrode 18 on the base substrate is at least partially overlapped with an orthographic projection of the compensation signal line 53 on the base substrate.

In an exemplary implementation, for two adjacent sub-pixels in the repeating unit in the first direction X, a sub-pixel without the first power supply line 51 is referred to as a non-power supply line sub-pixel, and a sub-pixel with the first power supply line 51 is referred to as a power supply line sub-pixel. A first distance between a storage capacitor in the non-power supply line sub-pixel and the compensation signal line may be greater than or equal to a second distance between a storage capacitor in the power supply line sub-pixel and the first power supply line. In an exemplary implementation, a distance between the storage capacitor and the compensation signal line may be a maximum distance between at least one electrode plate of the capacitor in the storage capacitor and the compensation signal line, and a distance between the storage capacitor and the first power supply line may be a maximum distance between at least one electrode plate of the capacitor in the storage capacitor and the first power supply line.

For example, the first power supply line 51 is provided in the second pixel column as an example. In the first pixel column, there is a first distance L1 between a right edge on a side of the first electrode plate 61 close to the compensation signal line 53 and a left edge on a side of the compensation signal line 53 close to the first electrode plate 61. In the second pixel column, there is a second distance L2 between a left edge on a side of the first electrode plate 61 close to the first power supply line 51 and a right edge on a side of the first power supply line 51 close to the first electrode plate 61. As another example, the first power supply line 51 is provided in the first pixel column as an example. In the first pixel column, there is a second distance L2 between a right edge on a side of the second electrode plate 62 close to the first power supply line 51 and a left edge on a side of the first power supply line 51 close to the second electrode plate 62. In the second pixel column, there is a first distance L1 between a left edge on a side of the second electrode plate 62 close to the compensation signal line 53 and a right edge on a side of the compensation signal line 53 close to the second electrode plate 62. The first distance L1 may be greater than or equal to the second distance L2, and the first distance L1 and the second distance L2 may be dimensions in the first direction X.

In an exemplary implementation, the first distance L1 and the second distance L2 may both be greater than a minimum distance between an edge on a side of the compensation signal line 53 close to the first power supply line 51 and an edge on a side of the first power supply line 51 close to the compensation signal line 53.

In an exemplary implementation, the first distance L1 may be greater than or equal to 3 microns.

According to the present disclosure, by setting a distance between the storage capacitor and the compensation signal line, the influence of the jump signal in the pixel driving circuit on the compensation signal line can be effectively reduced, ensuring the accuracy of the external compensation. Since the first power supply line is provided between the pixel driving circuit and the compensation signal line in the power supply line sub-pixel, the first power supply line with a constant potential can effectively shield the influence of the jump signal in the pixel driving circuit on the compensation signal line, so that a distance between the storage capacitor and the compensation signal line can be maintained or appropriately reduced under the premise of ensuring the accuracy of the external compensation.

The display substrate according to an embodiment of the present disclosure also has the technical effect of the foregoing embodiment, that is, it can effectively increase the aperture ratio, reduce the risk of pixel light leakage, effectively improve the process accuracy, effectively improve the product yield rate, and the like. In addition, according to an embodiment of the present disclosure, one first power supply line is reduced, which can effectively improve the space utilization rate and be beneficial to improving the resolution. According to an embodiment of the present disclosure, by setting a distance between the storage capacitor and the compensation signal line in different sub-pixels, the influence of the jump signal in the pixel driving circuit on the compensation signal line can be effectively reduced, ensuring the accuracy of the external compensation, the display effect and display quality.

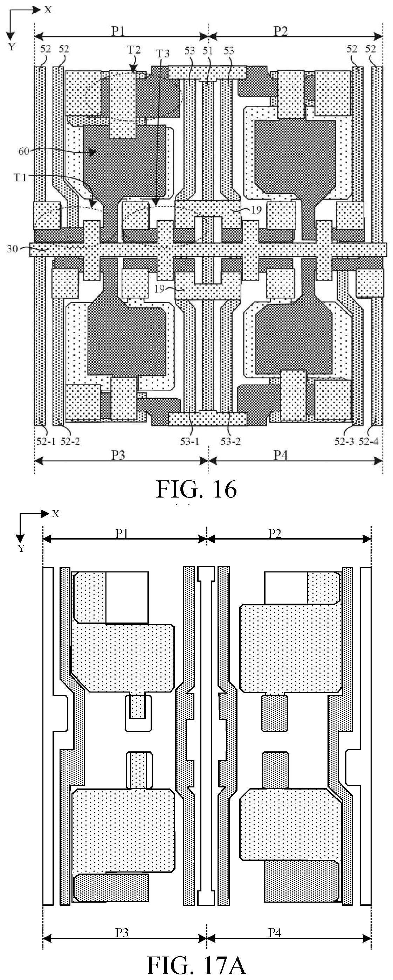

FIG. 15 is an equivalent circuit diagram of a pixel driving circuit in yet another repeating unit according to an exemplary embodiment of the present disclosure, and FIG. 16 is a schematic diagram of a structure of yet another display substrate according to an exemplary embodiment of the present disclosure. As shown in FIGS. 15 and 16, the pixel driving circuit and the main structure of the display substrate of the present embodiment are substantially the same as those of the embodiments shown in FIGS. 3 and 4, except that one repeating unit in the present embodiment is provided with one first power supply line 51 and two compensation signal lines 53.

In an exemplary implementation, at least one repeating unit may include a scan signal line 30, a first power supply line 51, four data signal lines 52, and two compensation signal lines 53. The shapes, positions, and a connection relationship with the pixel driving circuit, of scan signal line 30 and the data signal line 52 may be substantially the same as the embodiments shown in FIGS. 3 and 4. The pixel driving circuit of at least one sub-pixel may include a first transistor T1, a second transistor T2, a third transistor T3, and a storage capacitor 60, which may at least include a first electrode and a second electrode as electrode plates of the capacitor, and the related connection structure is substantially the same as the foregoing embodiment, which will not be repeated here.

In an exemplary implementation, one first power supply line 51 may be located in the middle of the repeating unit in the first direction X, and one first power supply line 51 may define two pixel columns: a first pixel column and a second pixel column. The two compensation signal lines 53 may include the first compensation signal line 53-1 and the second compensation signal line 53-2 sequentially arranged along the first direction X.

In an exemplary implementation, the first compensation signal line 53-1 may be provided on a side of the first power supply line 51 close to the first data signal line group, and the storage capacitor of the first pixel column may be provided between the second data signal line 52-2 and the first compensation signal line 53-1. The second compensation signal line 53-2 may be provided on a side of the first power supply line 51 close to the second data signal line group, and the storage capacitor of the second pixel column may be provided between the second compensation signal line 53-2 and the third data signal line 52-3.

In an exemplary implementation, the at least one repeating unit further includes two compensation connection electrodes 19, which may be located in the middle region of the repeating unit in the second direction Y, respectively. Each compensation connection electrode 19 may have a strip shape extending along the first direction X, and is provided across the first pixel column and the second pixel column. A first end of each compensation connection electrode 19 is connected to the first compensation signal line 53-1 and a first electrode of the third transistor T3 in the first pixel column, and a second end of each compensation connection electrode 19 is connected to the second compensation signal line 53-2 and a first electrode of the third transistor T3 in the second pixel column. In this way, the two compensation signal lines 53 and the two compensation connection electrodes 19 within the repeating unit form an annular structure for transmitting a compensation signal.

In an exemplary implementation, an orthographic projection of the compensation connection electrode 19 on the plane of the display substrate is not overlapped with an orthographic projection of the data signal line 52 on the plane of the display substrate.

In an exemplary implementation, an orthographic projection of the compensation connection electrode 19 on the plane of the display substrate is at least partially overlapped with an orthographic projection of the first power supply line 51 on the plane of the display substrate.

In an exemplary implementation, taking four sub-pixels in one repeating unit as an example, the preparation process of the display substrate of the present embodiment may include the following operations.

(21) A pattern of a first conductive layer is formed. In an exemplary embodiment, a process of forming the first conductive layer and a structure of the first conductive layer are substantially the same as in the foregoing embodiment.

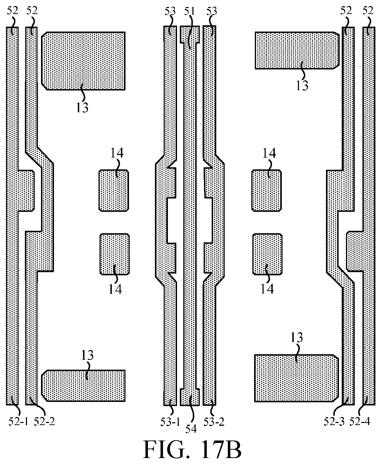

(22) A pattern of a second conductive layer is formed. In the exemplary embodiment, a process of forming the second conductive layer and a structure of the second conductive layer are substantially the same as in the foregoing embodiment, except that each repeating unit in the present embodiment includes one first power supply line 51 and two compensation signal lines 53. As shown in FIGS. 17A and 17B, FIG. 17B is a schematic diagram of the second conductive layer in FIG. 17A.

In an exemplary embodiment, shapes and positions of the third connection electrode 13, the fourth connection electrode 14, and the four data signal lines 52 in the second conductive layer of the present embodiment are substantially the same as those of the foregoing embodiments.

In the exemplary embodiment, the first power supply line 51, the data signal line 52, and the compensation signal line 53 may each have a straight line shape or a polygonal line shape in which a main body portion extends along the second direction Y. The first power supply line 51 may be located in the middle of the repeating unit in the first direction X, two compensation signal lines 53 may be located on both sides of the first power supply line 51 in the first direction X, two data signal lines 52 among the four data signal lines 52 may be located on a side in the repeating unit in a direction opposite to the first direction X, and the other two data signal lines 52 among the four data signal lines 52 may be located on a side of the repeating unit in the first direction X.

In an exemplary implementation, the two compensation signal lines 53 may include the first compensation signal line 53-1 and the second compensation signal line 53-2 sequentially arranged along the first direction X.

In an exemplary implementation, the first data signal line 52-1 and the first power supply line 51 may define a first pixel column, and the second data signal line 52-2 and the first compensation signal line 53-1 are arranged in the first pixel column. The second data signal line 52-2 may be arranged on a side of the first data signal line 52-1 close to the first power supply line 51, and the first compensation signal line 53-1 may be arranged on a side of the first power supply line 51 close to the first data signal line 52-1. The first electrode 61, the third connection electrode 13, and the fourth connection electrode 14 of the first pixel column may be arranged between the second data signal line 52-2 and the first compensation signal line 53-1.

In an exemplary implementation, the fourth data signal line 52-4 and the first power supply line 51 may define a second pixel column, the second compensation signal line 53-2 and the third data signal line 52-3 may be arranged in the second pixel column, the second compensation signal line 53-2 may be arranged on a side of the first power supply line 51 close to the fourth data signal line 52-4, and the third data signal line 52-3 may be arranged on a side of the fourth data signal line 52-4 close to the first power supply line 51. The first electrode plate 61, the third connection electrode 13 and the fourth connection electrode 14 of the second pixel column may be arranged between the second compensation signal line 53-2 and the third data signal line 52-3.

In an exemplary implementation, the first power supply line 51 may be connected with a power supply connection block 54, which may have a block shape, and is configured to be connected to a first region of the second active layer by a power supply connection electrode formed subsequently.

In an exemplary implementation, an orthographic projection of the first power supply line 51 on the base substrate is at least overlapped with an orthographic projection of the vertical reference line on the base substrate, positions of the two compensation signal lines 53 may be substantially mirror-symmetrical with respect to the vertical reference line, and positions of the two data signal lines 52 located on a side of the first power supply line 51 in the opposite direction of the first direction X and positions of the two data signal lines 52 located on a side of the first power supply line 51 in the first direction X may be substantially mirror-symmetrical with respect to the vertical reference line.

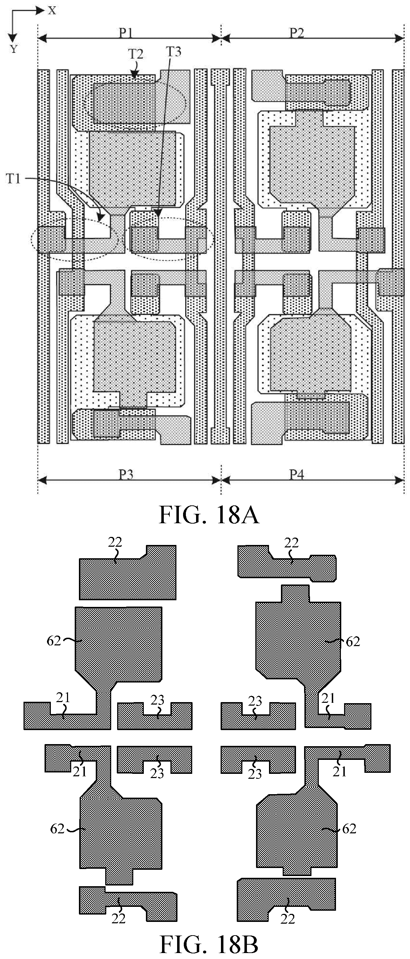

(23) A pattern of a semiconductor layer is formed. In the exemplary implementation, a process of forming the semiconductor layer and a structure of the semiconductor layer are substantially the same as in the foregoing embodiment, except that the third active layer 23 of each sub-pixel in the present embodiment is provided separately. As shown in FIGS. 18A and 18B, FIG. 18B is a schematic diagram of the semiconductor layer in FIG. 18A.

In the exemplary implementation, shapes and positions of the first active layer 21, the second active layer 22, and the second electrode plate 62 of the storage capacitor in the semiconductor layer of the present embodiment are substantially the same as those of the foregoing embodiment.

In an exemplary implementation, the third active layer 23 of each sub-pixel may have a strip shape extending along the first direction X. An orthographic projection of one end of the third active layer 23 on the base substrate is at least partially overlapped with an orthographic projection of the fourth connection electrode 14 of the present sub-pixel on the base substrate, and an orthographic projection of the other end of the third active layer 23 on the base substrate is at least partially overlapped with an orthographic projection of the compensation signal line 53 on the base substrate.

In the exemplary implementation, the third active layers 23 in the first sub-pixel P1 and the second sub-pixel P2 are not connected, the third active layers 23 in the third sub-pixel P3 and the fourth sub-pixel P4 are not connected, and an orthographic projection of the third active layer 23 on the base substrate is not overlap with an orthographic projection of the first power supply line 51 on the base substrate.

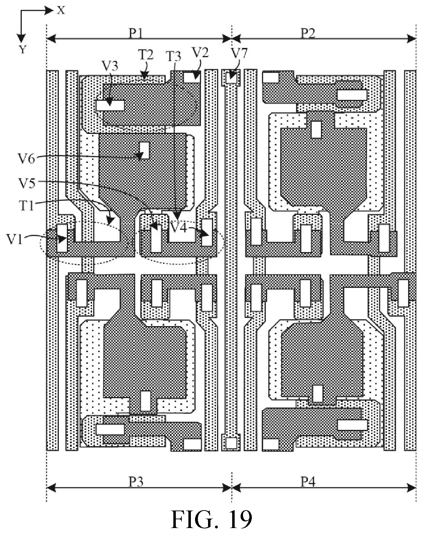

(24) A pattern of a second insulation layer is formed. In the exemplary implementation, a process of forming the second insulation layer pattern and a structure of the plurality of vias are substantially the same as in the foregoing embodiment, except that the seventh via V7 is also provided in this embodiment, as shown in FIG. 19.

In the exemplary implementation, the positions and functions of the first via V1, the third via V3, the fourth via V4, the fifth via V5, and the sixth via V6 are substantially the same as those of the foregoing embodiments.

In an exemplary implementation, an orthographic projection of the second via V2 on the base substrate is located within a range of an orthographic projection of the first region of the second active layer 22 on the base substrate, the second insulation layer within the second via V2 is etched away to expose a surface of the first region of the second active layer 22, and the second via V2 is configured to connect a power supply connection electrode to be formed subsequently to the first region of the second active layer 22 through the second via V2.

In an exemplary implementation, each sub-pixel further includes a seventh via V7. An orthographic projection of the seventh via V7 on the base substrate is located within a range of an orthographic projection of the power supply connection block 54 of the first power supply line 51 on the base substrate, the first insulation layer and the second insulation layer within the fifth via V7 are etched away to expose a surface of the power supply connection block 54, and the seventh via V7 is configured such that a power supply connection electrode subsequently formed is connected to the power supply connection block 54 through the via V7.

In the exemplary implementation, unlike the foregoing embodiment, each sub-pixel is provided with a fourth via V4, that is, the first sub-pixel P1 and the second sub-pixel P2 do not share the fourth via V4, and the third sub-pixel P3 and the fourth sub-pixel P4 do not share the fourth via V4.

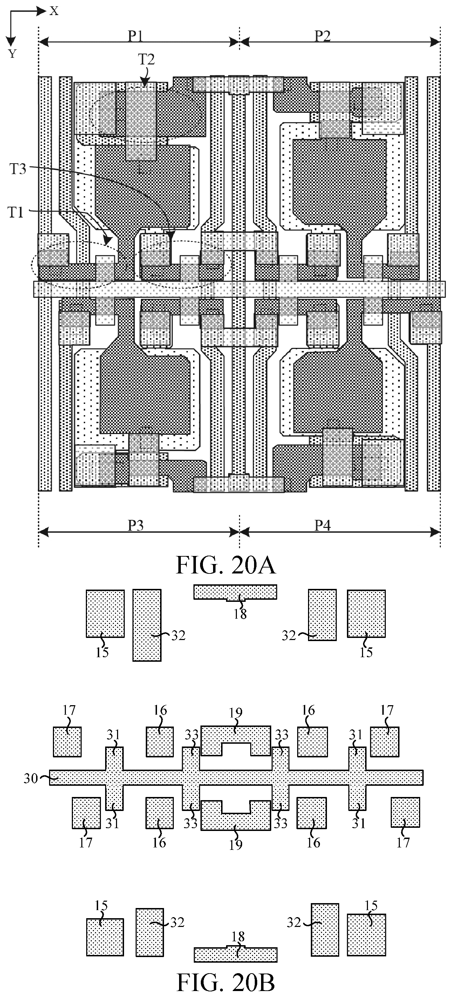

(25) A pattern of a third conductive layer is formed. In an exemplary implementation, a process of forming the third conductive layer and a structure of the third conductive layer are substantially the same as those of the foregoing embodiments, except that in the present embodiment, a connection structure of the power supply connection electrode 18 is different from a connection structure of the compensation connection electrode 19. As shown in FIGS. 20A and 20B, FIGS. 20B is a schematic diagram of the third conductive layer in FIG. 20A.

In the exemplary implementation, shapes and positions of the fifth connection electrode 15, the sixth connection electrode 16, the data connection electrode 17, the scan signal line 30, the first gate electrode 31, the second gate electrode 32, and the third gate electrode 33 in the third conductive layer of the present embodiment are substantially the same as those of the foregoing embodiment.

In the exemplary implementation, the power supply connection electrode 18 may have a strip shape extending along the first direction X, may be arranged on a side of the second electrode plate 62 away from the scan signal line 30, and may be provide across the first pixel column and the second pixel column. A first end of the power supply connection electrode 18 is connected to a first region of the second active layer 22 in the first pixel column through the second via V2 in the first pixel column, a second end of the power supply connection electrode 18 is connected to a first region of the second active layer 22 in the second pixel column through the second via V2 in the second pixel column, and a middle region between the first end and the second end of the power supply connection electrode 18 is connected to the power supply connection block 54 through the seventh via V7. Since the power supply connection electrode 54 is connected to the power supply connection line 51, writing of the first power supply signal into the first electrode of the second transistor T2 by the first power supply line 51 is achieved.

In an exemplary implementation, the first power supply line 51 may simultaneously provide a first power supply signal to four pixel driving circuits in the first pixel column and the second pixel column, so that the first power supply line 51 in one repeating unit has a one-drag-four structure. In the display substrate according to the present disclosure, a first power supply line is designed to have a one-drag-four structure, which saves a quantity of signal lines, reduces occupied space, has a simple structure and a reasonable layout, makes full use of layout space, improves a space utilization rate, and is beneficial to improving a resolution and transparency.

In the exemplary embodiment, the power supply connection electrode 18 may serve as a transverse power supply connection line, an orthographic projection of the power supply connection electrode 18 on the base substrate is not overlapped with an orthographic projection of the data signal line 52 on the base substrate, and an orthographic projection of the power supply connection electrode 18 on the base substrate is at least partially overlapped with an orthographic projection of the compensation signal line 53 on the base substrate.

In the exemplary implementation, the compensation connection electrode 19 may have a strip shape extending along the first direction X, and may be provided across the first pixel column and the second pixel column. A first end of the compensation connection electrode 19 is simultaneously connected to a first region of the third active layer 23 in the first pixel column and the compensation signal line 53 through the fourth via V4 in the first pixel column, and a second end of the compensation connection electrode 19 is simultaneously connected to a first region of the third active layer 23 in the second pixel column and the compensation signal line 53 through the fourth via V4 in the second pixel column, thus achieving that the compensation signal line 53 writes a compensation signal to the first electrode of the third transistor T3.

In an exemplary implementation, the two compensation signal lines 53 may include the first compensation signal line 53-1 and the second compensation signal line 53-2 sequentially arranged along the first direction X. The first compensation signal line 53-1 may be located in the first pixel column on a side of the first power supply line 51 in a direction opposite to the first direction X, and may be connected to first regions of the third active layers 23 in the first sub-pixel P1 and the third sub-pixel P3 through the compensation connection electrode 19, respectively. The second compensation signal line 53-2 may be located in the second pixel column on a side of the first power supply line 51 in the first direction X, and may be connected to first regions of the third active layers 23 in the second sub-pixel P2 and the fourth sub-pixel P4 through the compensation connection electrode 19, respectively.

In an exemplary implementation, although the third active layers in the first sub-pixel P1 and the second sub-pixel P2 are not connected, and the third active layer in the third sub-pixel P3 and the fourth sub-pixel P4 are not connected, the present disclosure provides a compensation connection electrode 19 provided across the first pixel column and the second pixel column, and the compensation connection electrode 19 can serve as a transverse compensation connection line, so that the first sub-pixel P1 and the second sub-pixel P2 share one compensation connection electrode 19, and the third sub-pixel P3 and the fourth sub-pixel P4 share one compensation connection electrode 19. Two compensation signal lines 53 can simultaneously provide a compensation signal to the pixel driving circuits in the four sub-pixels, so that four pixel driving circuits in one repeating unit can share two compensation signal lines 53, and the compensation signal lines 53 in one repeating unit have a one-drag-two structure. In the display substrate according to the present disclosure, a compensation signal line is designed to have a one-drag-two structure, which saves a quantity of signal lines, reduces occupied space, has a simple structure and a reasonable layout, makes full use of layout space, improves a space utilization rate, and is beneficial to improving a resolution.

In an exemplary implementation, the present disclosure provides a compensation connection electrode 19 provided across the first pixel column and the second pixel column, and forms an annular structure in a region where the compensation signal line 53 is connected to the third transistor T3 in the repeating unit, which is beneficial to improving the product yield rate. For example, when there is a short circuit defect at a position where the power supply connection electrode 18, which serves as a transverse power supply connection line, crosses the compensation signal line 53, the short circuit defect can be repaired by truncating one of the compensation signal lines 53, thereby improving the product yield rate. As another example, when there is a short circuit defect at a position where the compensation connection electrode 19 crosses the first power supply line 51, the short circuit defect can be repaired by truncating one of the compensation connection electrodes 19, thereby improving the product yield rate.

In the exemplary implementation, an orthographic projection of the compensation connection electrode 19 on the base substrate is not overlapped with an orthographic projection of the data signal line 52 on the base substrate, and the orthographic projection of the compensation connection electrode 19 on the base substrate is at least partially overlapped with an orthographic projection of the first power supply line 51 on the base substrate.

In the exemplary implementation, since positions of the two compensation signal lines 53 are substantially mirror-symmetrical with respect to the vertical reference line, and the third transistor T3 of the first pixel column and the third transistor T3 of the second pixel column are substantially mirror-symmetrical with respect to the vertical reference line, the symmetrical structure of the present disclosure can ensure that the RC delay of writing the compensation signal to the third transistor T3 is substantially the same, ensuring display uniformity.

(26) The subsequent process of forming a third insulation layer, a planarization layer, a fourth conductive layer, a pixel definition layer, an organic light emitting layer, a cathode, and an encapsulation structure layer is substantially the same as the foregoing embodiment, which will not be described here in detail.

In the display substrate according to an embodiment of the present disclosure, the first power supply line and the compensation signal line are arranged in the middle of the repeating unit, and the data signal line is arranged on both sides of the repeating unit, which effectively balances a distance distribution of the opaque metal signal line between sub-pixels, and thus also has the technical effect of the foregoing embodiment, that is, it can effectively increase the aperture ratio, reduce the risk of pixel light leakage, effectively improve the process accuracy, effectively improve the product yield, and the like. In addition, an embodiment of the present disclosure provides a separate third active layer in each sub-pixel, and an orthographic projection of the third active layer on the base substrate is not overlapped with an orthographic projection of the first power supply line on the base substrate, thereby effectively reducing an extension length of the semiconductor trace, effectively avoiding an influence of the difference in the conductivity process on the external compensation, ensuring the accuracy of the external compensation, and ensuring the display effect and display quality. Further, an embodiment of the present disclosure provides a compensation connection electrode provided across the first pixel column and the second pixel column, and an annular structure is formed in a region where the compensation signal line is connected to the third transistor, which is convenient for short-circuit repair and is beneficial to improving the product yield rate.

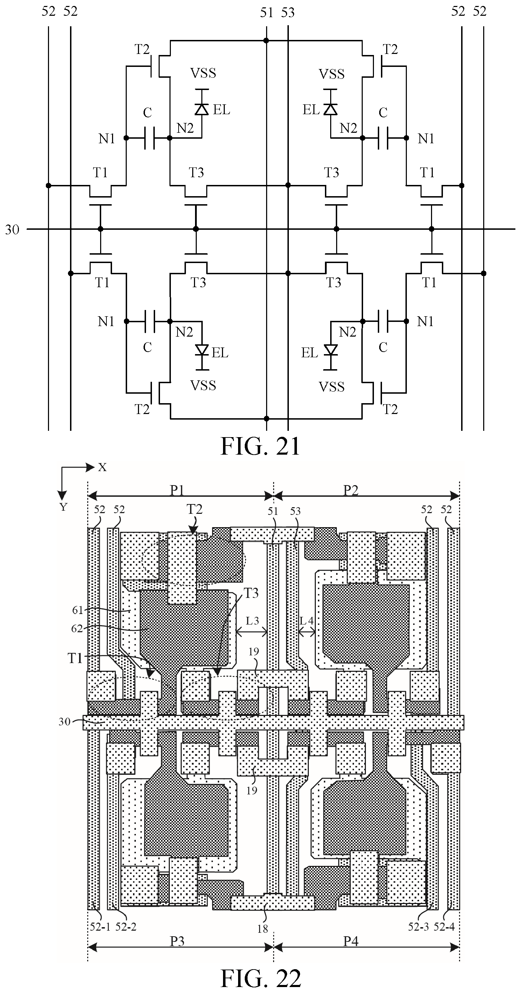

FIG. 21 is an equivalent circuit diagram of a pixel driving circuit in yet another repeating unit according to an exemplary embodiment of the present disclosure, and FIG. 22 is a schematic diagram of a structure of yet another display substrate according to an exemplary embodiment of the present disclosure. As shown in FIGS. 21 and 22, the pixel driving circuit and the main structure of the display substrate of the present embodiment are substantially the same as those of the embodiments shown in FIGS. 15 and 16, except that one repeating unit in the present embodiment is provided with one compensation signal line 53.

In an exemplary implementation, at least one repeating unit may include a scan signal line 30, a first power supply line 51, four data signal lines 52, and one compensation signal line 53. Shapes, positions, and a connection relationship with the pixel driving circuit, of the scan signal line 30, the data signal line 52 and the first power supply line 51 may be substantially the same as the embodiments shown in FIGS. 15 and 16. The pixel driving circuit of at least one sub-pixel may include a first transistor T1, a second transistor T2, a third transistor T3, and a storage capacitor 60, which may at least include a first electrode 61 and a second electrode 62 as electrode plates of the capacitor, and the related connection structure is substantially the same as the foregoing embodiment, which will not be repeated here.

In an exemplary implementation, the compensation signal line 53 may be provided on a side of the first power supply line 51 in the first direction X, that is, the compensation signal line 53 is provided on a side of the second pixel column close to the first power supply line 51. In another exemplary implementation, the compensation signal line 53 may be provided on a side of the first power supply line 51 in a direction opposite to the first direction X, that is, the compensation signal line 53 is provided on a side of the first pixel column close to the first power supply line 51.

In the exemplary implementation, a shape and a position of the compensation connection electrode 19 are substantially the same as those of the embodiments shown in FIGS. 15 and 16, except that a first end of the compensation connection electrode 19 is simultaneously connected to a first region of the third active layer 23 in the pixel column and the compensation signal line 53 through the fourth via V4 in one pixel column, and a second end of the compensation connection electrode 19 is connected to a first region of the third active layer 23 in the pixel column through the fourth via V4 in one other pixel column, thereby achieving that one compensation signal line 53 writes a compensation signal to the first electrodes of the four third transistors T3 in two pixel columns, and forming an one-drag-four structure of the compensation signal line, which saves the number of signal lines, and reduces the occupied space, implementing a simple structure and a reasonable layout, making full use of the layout space, improving a space utilization rate, which is beneficial to improving a resolution.

In the exemplary embodiment, the compensation connection electrode 19 may serve as a transverse compensation connection line. An orthographic projection of the compensation connection electrode 19 on the base substrate is not overlapped with an orthographic projection of the data signal line 52 on the base substrate, and the orthographic projection of the compensation connection electrode 19 on the base substrate is at least partially overlapped with an orthographic projection of the first power supply line 51 on the base substrate.

In an exemplary implementation, the compensation signal line 53 is provided in the second pixel column as an example. In the first pixel column, there is a third distance L3 between a right edge on a side of the first electrode plate 61 close to the first power supply line 51 and a left edge on a side of the first power supply line 51 close to the first electrode plate 61. In the second pixel column, there is a fourth distance L4 between a left edge on a side of the first electrode plate 61 close to the compensation signal line 53 and a right edge on a side of the compensation signal line 53 close to the first electrode plate 61. In another exemplary implementation, the compensation signal line 53 is provided in the first pixel column as an example. In the first pixel column, there is a fourth distance L4 between a right edge on a side of the second electrode plate 62 close to the compensation signal line 53 and a left edge on a side of the compensation signal line 53 close to the second electrode plate 62. In the second pixel column, there is a third distance L3 between a left edge on a side of the second electrode plate 62 close to the first power supply line 51 and a right edge on a side of the first power supply line 51 close to the second electrode plate 62. The third distance L3 and the fourth distance L4 may both be greater than a minimum distance between an edge of the first power supply line 51 close to the compensation signal line 53 and an edge of the compensation signal line 53 close to the first power supply line 51, and the third distance L3 and the fourth distance L4 may a dimension in the first direction X.

In an exemplary implementation, the fourth distance L4 may be greater than or equal to 3 microns.

According to the present disclosure, by setting a distance between the storage capacitor in the non-compensation line sub-pixel and the first power supply line, the space utilization rate can be effectively improved under the premise of ensuring the accuracy of the external compensation, which is beneficial to improving the resolution.

The display substrate according to an embodiment of the present disclosure also has the technical effect of the foregoing embodiment, that is, it can effectively increase the aperture ratio, reduce the risk of pixel light leakage, effectively improve the process accuracy, effectively improve the product yield rate, and the like. In addition, according to an embodiment of the present disclosure, one compensation signal line is reduced, which can effectively improve the space utilization rate and be beneficial to improving the resolution. According to the present disclosure, by setting a distance between the storage capacitor in different sub-pixel and the first power supply line, the space utilization rate is further improved under the premise of ensuring the accuracy of the external compensation, which further improves the resolution.

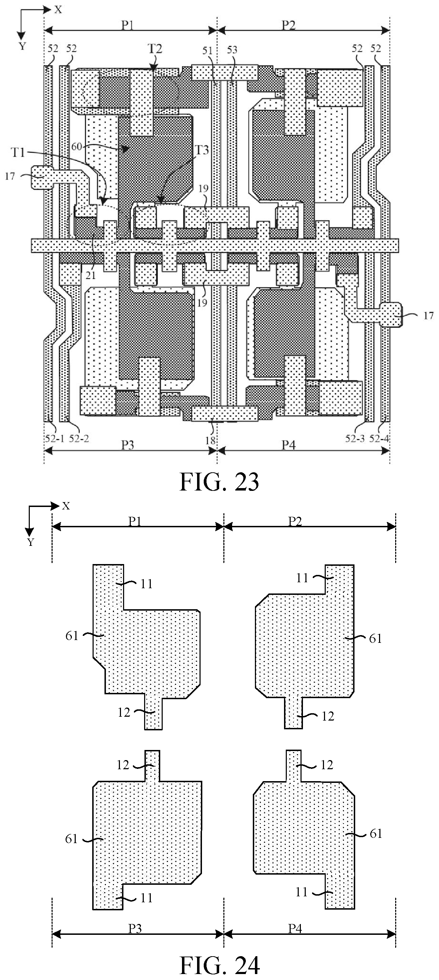

FIG. 23 is a schematic structural diagram of another display substrate according to an exemplary embodiment of the present disclosure. As shown in FIG. 23, the main structure of the pixel driving circuit and the display substrate of the present embodiment is substantially the same as those of the embodiment shown in FIG. 22, except that the first active layers in the first sub-pixel and the fourth sub-pixel of the present embodiment is not overlapped with the data signal line.

In an exemplary implementation, at least one repeating unit may include one scan signal line 30, one first power supply line 51, four data signal lines 52, and one compensation signal line 53, which may be provided on a side of the first power supply line 51 in the first direction X.

In an exemplary implementation, shapes and connection structures of the data connection electrodes 17 in the second sub-pixel P2 and the third sub-pixel P3 are substantially the same as in the foregoing embodiment. The data connection electrodes 17 in the first sub-pixel P1 and the fourth sub-pixel P4 may have an "L" shape. A first end of the data connection electrode 17 is simultaneously connected to a first region of the first active layer and the data bridging electrode through the via, a second end of the data connection electrode 17 is connected to the data signal line through the via, and an orthographic projection of the data connection electrode 17 on the base substrate is at least partially overlapped with an orthographic projection of the data signal line 52 on the base substrate.

In an exemplary implementation, orthographic projections of the first active layers in the first sub-pixel P1 and the fourth sub-pixel P4 on the base substrate is not overlapped with an orthographic projection of the data signal line 52 on the base substrate.

In an exemplary implementation, taking four sub-pixels in one repeating unit as an example, the preparation process of the display substrate of the present embodiment may include the following operations.

(31) A pattern of a first conductive layer is formed. In an exemplary implementation, a process of forming the first conductive layer and a structure of the first conductive layer are substantially the same as in the foregoing embodiment, as shown in FIG. 24.

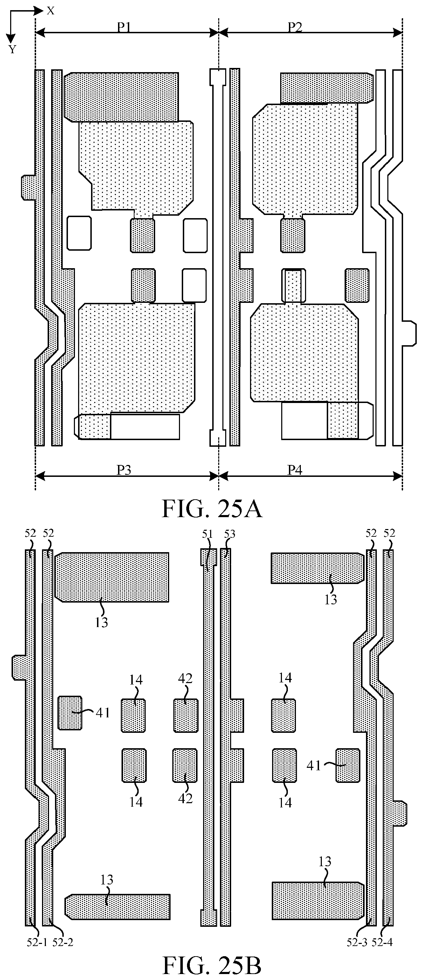

(32) A pattern of a second conductive layer is formed. In the exemplary implementation, a process of forming the second conductive layer and a structure of the second conductive layer are substantially the same as in the foregoing embodiment, except that the second conductive layer in the present embodiment includes a data bridging electrode 41 and a data bridging electrode 42. As shown in FIGS. 25A and 25B, FIG. 25B is a schematic diagram of the second conductive layer in FIG. 25A.

In an exemplary implementation, shapes and positions of the third connection electrode 13, the fourth connection electrode 14, and the four data signal lines 52 in the second conductive layer of the present embodiment are substantially the same as those of the foregoing embodiments.

In the exemplary implementation, the first power supply line 51, the data signal line 52, and the compensation signal line 53 may have a straight line or a polygonal line in which a main body portion extends along the second direction Y, the first power supply line 51 may be located in the middle of the repeating unit in the first direction X, and the compensation signal line 53 may be located on a side of the first power supply line 51 in the first direction X.

In an exemplary implementation, the data bridging electrode 41 may have a block (rectangular) shape and may be provided between the fourth connection electrode 14 and the data signal line 52 in the first sub-pixel P1 and the fourth sub-pixel P4. The data bridging electrode 41 is configured to be connected to the data signal line through a data connection electrode formed subsequently.

In an exemplary implementation, the compensation bridging electrode 42 may have a block (rectangular) shape, and may be provided between the fourth connection electrode 14 and the first power supply line 51 in the first pixel column. The compensation bridging electrode 42 is configured to be connected to the compensation signal line through a compensation connection electrode formed subsequently.

In an exemplary implementation, the first electrode 61, the third connection electrode 13, the fourth connection electrode 14, the data bridging electrode 41, and the compensation bridging electrode 42 of the first pixel column may be arranged between the second data signal line 52-2 and the first power supply line 51, and the first electrode 61, the third connection electrode 13, the fourth connection electrode 14, and the data bridging electrode 41 of the second pixel column may be provided between the compensation signal line 53 and the third data signal line 52-3.

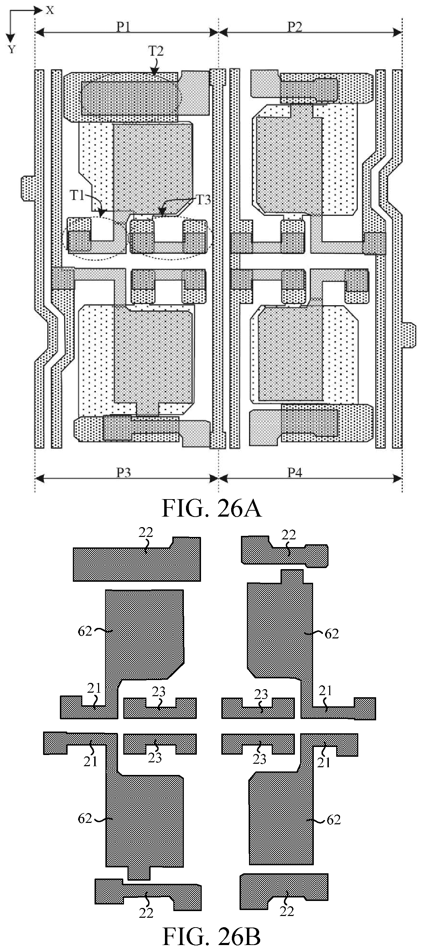

(33) A pattern of a semiconductor layer is formed. In the exemplary implementation, a process of forming the semiconductor layer and a structure of the semiconductor layer are substantially the same as in the foregoing embodiment, except that the first active layers 21 of the first sub-pixel P1 and the fourth sub-pixel P4 are not overlapped with the data signal line 51. As shown in FIGS. 26A and 26B, FIG. 26B is a schematic diagram of the semiconductor layer in FIG. 26A.

In the exemplary implementation, shapes and positions of the second active layer 22, and the second electrode plate 62 of the storage capacitor in the semiconductor layer of the present embodiment are substantially the same as those of the foregoing embodiment.

In an exemplary implementation, the first active layer 21 of each sub-pixel may have a shape of a strip extending along the first direction X. In the first sub-pixel P1 and the fourth sub-pixel P4, an orthographic projection of a first region of the first active layer 21 on the base substrate is at least partially overlapped with an orthographic projection of the data bridging electrode 41 on the base substrate, a second region of the first active layer 21 is connected to the second electrode plate 62, and an orthographic projection of the first active layer 21 on the base substrate is not overlapped with an orthographic projection of the data signal line 52 on the base substrate. In the second sub-pixel P2 and the third sub-pixel P3, an orthographic projection of a first region of the first active layer 21 on the base substrate is at least partially overlapped with an orthographic projection of a corresponding data signal line 52 on the base substrate, and a second region of the first active layer 21 is connected to the second electrode plate 62.

In an exemplary implementation, the third active layer 23 of each sub-pixel may have a shape of a strip extending along the first direction X. In the first sub-pixel P1 and the third sub-pixel P3, an orthographic projection of one end of the third active layer 23 on the base substrate is at least partially overlapped with an orthographic projection of the fourth connection electrode 14 of the present sub-pixel on the base substrate, and an orthographic projection of the other end of the third active layer 23 on the base substrate is at least partially overlapped with an orthographic projection of the compensation bridging electrode 42 on the base substrate. In the second sub-pixel P2 and the fourth sub-pixel P4, an orthographic projection of one end of the third active layer 23 on the base substrate is at least partially overlapped with an orthographic projection of the fourth connection electrode 14 of the present sub-pixel on the base substrate, and an orthographic projection of the other end of the third active layer 23 on the base substrate is at least partially overlapped with an orthographic projection of the compensation signal line 53 on the base substrate.

In an exemplary implementation, an orthographic projection of the third active layer 23 of each sub-pixel on the base substrate is not overlapped with an orthographic projection of the first power supply line 51 on the base substrate.

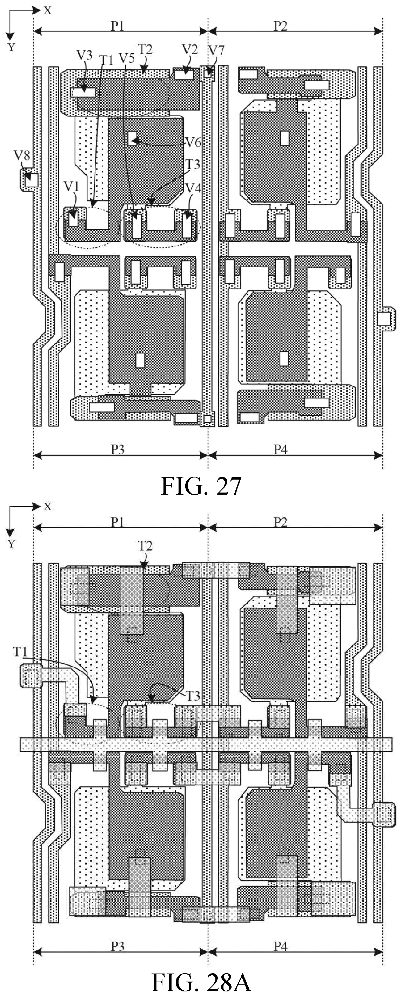

(34) A pattern of a second insulation layer is formed. In the exemplary implementation, a process of forming the second insulation layer pattern and a structure of the plurality of vias are substantially the same as in the foregoing embodiment, except that the eighth via V8 is also provided in this embodiment, as shown in FIG. 27.

In the exemplary implementation, the positions and functions of the third via V3, the fifth via V5, and the sixth via V6 are substantially the same as those of the foregoing embodiments.

In an exemplary implementation, in the first sub-pixel P1 and the fourth sub-pixel P4, an orthogonal projection of the first via V1 on the base substrate is at least partially overlapped with an orthogonal projection of a first region of the first active layer 21 on the base substrate, and an orthogonal projection of the first via V1 on the base substrate is at least partially overlapped with an orthogonal projection of the data bridging electrode 41 on the base substrate. The first via V1 is a via of an transfer structure including two half-holes, the second insulation layer in a shallow half hole is etched away, exposing a surface of a first region of the first active layer 21, and the first insulation layer and the second insulation layer in a deep half-hole are etched away, exposing a surface of the data bridging electrode 41, such that the first via V1 of the transfer structure composed of the two half holes simultaneously exposes a first region of the first active layer 21 and the data bridging electrode 41. In the second sub-pixel P2 and the third sub-pixel P3, an orthographic projection of the first via V1 on the base substrate is located within a range of orthographic projections of a first region of the first active layer 21 and the data signal line 52 on the base substrate. The first via V1 is a via of a transition structure, and a connection structure is substantially the same as that of the aforementioned embodiment.

In an exemplary implementation, an orthographic projection of the second via V2 of each sub-pixel on the base substrate is located within a range of an orthographic projection of a first region of the second active layer 22 on the base substrate, and the second insulation layer within the second via V2 are etched away, exposing a surface of the first region of the second active layer 22.

In an exemplary implementation, in the first sub-pixel P1 and the third sub-pixel P3, an orthographic projection of the fourth via V4 on the base substrate is at least partially overlapped with an orthographic projection of a first region of the third active layer 23 on the base substrate, and an orthographic projection of the fourth via V4 on the base substrate is at least partially overlapped with an orthographic projection of the compensation bridging electrode 42 on the base substrate. The fourth via V4 is a via of a transfer structure including two half holes. The second insulation layer within the shallow half hole is etched away to expose a surface of the first region of the third active layer 23, the first insulation layer and the second insulation layer within the deep half hole are etched away to expose a surface of the compensation bridging electrode 42, such that the fourth via V4 of the transfer structure composed of the two half holes simultaneously exposes a first region of the third active layer 23 and the compensation bridging electrode 42. In the second sub-pixel P2 and the fourth sub-pixel P4, an orthographic projection of the fourth via V4 on the base substrate is located within a range of an orthographic projections of a first region of the third active layer 23 and the compensation signal line 53 on the base substrate. The fourth via V4 is a via of a transfer structure, and a connection structure is substantially the same as that of the foregoing embodiment.

In an exemplary implementation, each sub-pixel further includes a seventh via V7. An orthographic projection of the seventh via V7 on the base substrate is located within a range of an orthographic projection of a first power supply line 51 on the base substrate. The first insulation layer and the second insulation layer in the seventh via V7 are etched away to expose a surface of the first power supply line 51.

In an exemplary implementation, the first sub-pixels P1 and the fourth sub-pixels P4 also include an eighth via V8. An orthographic projection of the eighth via V8 on the base substrate is located within a range of an orthographic projection of a data signal line 52 on the base substrate. The first insulation layer and the second insulation layer in the eighth via V8 are etched away to expose a surface of the data signal line 52.

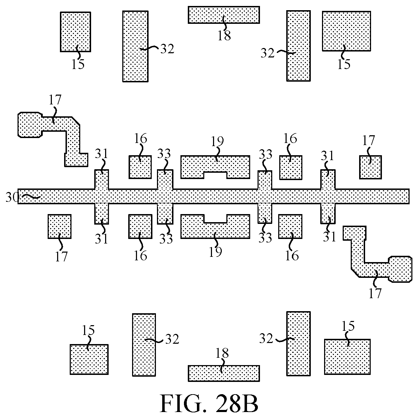

(35) A pattern of a third conductive layer is formed. In an exemplary implementation, a process of forming the third conductive layer and a structure of the third conductive layer are substantially the same as those of the foregoing embodiments, except that in the present embodiment, a connection structure of the power supply connection electrode 18 is different from a connection structure of the compensation connection electrode 19. As shown in FIGS. 28A and 28B, FIGS. 28B is a schematic diagram of the third conductive layer in FIG. 28A.

In the exemplary implementation, shapes and positions of the fifth connection electrode 15, the sixth connection electrode 16, the scan signal line 30, the first gate electrode 31, the second gate electrode 32, and the third gate electrode 33 in the third conductive layer of the present embodiment are substantially the same as those of the foregoing embodiment.

In an exemplary implementation, the data connection electrodes 17 in the first sub-pixel P1 and the fourth sub-pixel P4 may have an "L" shape. A first end of the data connection electrode 17 is simultaneously connected to a first region of the first active layer 21 and the data bridging electrode 41 through the first via V1, and a second end of the data connection electrode 17 is connected to the data signal line 52 through the eighth via V8. The data connection electrodes 17 in the second sub-pixel P2 and the third sub-pixel P3 may have a block shape. The data connection electrodes 17 are simultaneously connected to a first region of the first active layer 21 and the data signal line 52 through the first via V1, and the connection structure is substantially the same as the foregoing embodiment.

In an exemplary implementation, the data connection electrode 17 in the first sub-pixel P1 is connected to the first data signal line 52-1, and an orthographic projection of the data connection electrode 17 on the base substrate is at least partially overlapped with an orthographic projection of the second data signal line 52-2 on the base substrate. The data connection electrode 17 in the fourth sub-pixel P4 is connected to the fourth data signal line 52-4, and an orthographic projection of the data connection electrode 17 on the base substrate is at least partially overlapped with an orthographic projection of the third data signal line 52-3 on the base substrate.

In the exemplary implementation, the power supply connection electrode 18 may have a strip shape extending along the first direction X, may be arranged on a side of the second electrode plate 62 away from the scan signal line 30, and may be provide across the first pixel column and the second pixel column. A first end of the power supply connection electrode 18 is connected to a first region of the second active layer 22 in the first pixel column through the second via V2 in the first pixel column, a second end of the power supply connection electrode 18 is connected to a first region of the second active layer 22 in the second pixel column through the second via V2 in the second pixel column, and a middle region between the first end and the second end of the power supply connection electrode 18 is connected to the first power supply connection line 51 through the seventh via V7, thus achieving that the first power supply line 51 writes a first power supply signal to the first electrode of the second transistor T2.

In the exemplary embodiment, the power supply connection electrode 18 may serve as a transverse power supply connection line, an orthographic projection of the power supply connection electrode 18 on the base substrate is not overlapped with an orthographic projection of the data signal line 52 on the base substrate, and an orthographic projection of the power supply connection electrode 18 on the base substrate is at least partially overlapped with an orthographic projection of the compensation signal line 53 on the base substrate.

In an exemplary implementation, the compensation connection electrode 19 may have a strip shape extending along the first direction X, and may be provided across the first pixel column and the second pixel column. A first end of the compensation connection electrode 19 is simultaneously connected to a first region of the third active layer 23 in the first pixel column and the compensation bridging electrode 42 through the fourth via V4 in the first pixel column, and a second end of the compensation connection electrode 19 is simultaneously connected to a first region of the third active layer 23 in the second pixel column and the compensation signal line 53 through the fourth via V4 in the second pixel column, thus achieving that the compensation signal line 53 writes a compensation signal to the first electrode of the third transistor T3.

In the exemplary implementation, an orthographic projection of the compensation connection electrode 19 on the base substrate is not overlapped with an orthographic projection of the data signal line 52 on the base substrate, and the orthographic projection of the compensation connection electrode 19 on the base substrate is at least partially overlapped with an orthographic projection of the first power supply line 51 on the base substrate.

(36) The subsequent process of forming a third insulation layer, a planarization layer, a fourth conductive layer, a pixel definition layer, an organic light emitting layer, a cathode, and an encapsulation structure layer is substantially the same as the foregoing embodiment, which will not be described here in detail.

In the display substrate according to an embodiment of the present disclosure, the first power supply line and the compensation signal line are arranged in the middle of the repeating unit, and the data signal line is arranged on both sides of the repeating unit, which effectively balances a distance distribution of the opaque metal signal line between sub-pixels, and thus also has the technical effect of the foregoing embodiment, that is, it can effectively increase the aperture ratio, reduce the risk of pixel light leakage, effectively improve the process accuracy, effectively improve the product yield, and the like. According to ab embodiment of the present disclosure, by providing one first power supply line and one compensation signal line, the space utilization rate can be effectively improved and is beneficial to improving the resolution. An embodiment of the present disclosure provides a separate third active layer in each sub-pixel, and an orthographic projection of the third active layer on the base substrate is not overlapped with an orthographic projection of the first power supply line on the base substrate, thereby effectively reducing an extension length of the semiconductor trace, effectively avoiding an influence of the difference in the conductivity process on the external compensation, ensuring the accuracy of the external compensation, and ensuring the display effect and display quality. Further, according to an embodiment of the present disclosure, a data bridging electrode are provided in the first sub-pixel and the fourth sub-pixel, and the data signal line on an outer side can be connected to the first transistor through a data connection electrode of the metal material, thereby avoiding the use of a conductorized semiconductor layer as a cross-line overlapping trace, effectively avoiding the display unevenness caused by a difference in conductorized resistance, and improving the display effect and display quality.

Although the present embodiment is illustrated with the structure shown in FIG. 22, the structures of the data connection electrode and the data bridging electrode of the present embodiment can also be applied to the embodiments shown in FIGS. 4, 14, and 16.

A structure shown in the present disclosure and a preparation process thereof are merely exemplary description. In an exemplary implementation, a corresponding structure may be changed and patterning processes may be added or reduced according to actual needs, which is not limited here in the present disclosure.

In an exemplary implementation, the display substrate according to the present disclosure may be applied to a display apparatus with a pixel driving circuit, such as an OLED, a quantum dot display (QLED), a light emitting diode display (Micro LED or Mini LED), or a Quantum Dot Light Emitting Diode display (QDLED), which is not limited here in the present disclosure.

An embodiment of the present disclosure further provides a method for preparing a display substrate, which includes a plurality of repeating units, and the method includes:
forming at least one first power supply line, at least one compensation signal line, at least two data signal line groups, and a plurality of sub-pixels in at least one repeating unit, wherein the plurality of sub-pixels form at least two pixel rows and at least two pixel columns, and the data signal line group includes at least one data signal line; at least one sub-pixel includes a pixel driving circuit, and the pixel driving circuit at least includes a storage capacitor; the first power supply line and the compensation signal line are arranged between two adjacent pixel columns in the repeating unit, and the at least two data signal line groups are respectively arranged on both sides, in a direction of the pixel rows, of the repeating unit; and the storage capacitor is arranged between the data signal line and the first power supply line, or the storage capacitor is arranged between the data signal line and the compensation signal line.

The present disclosure also provides a display apparatus which includes the display substrate according to the aforementioned embodiments. The display apparatus may be any product or component with a display function, such as a mobile phone, a tablet computer, a television, a display, a laptop computer, a digital photo frame, and a navigator.

Although implementations disclosed in the present disclosure are as above, it should be noted that the above implementations are exemplary only rather than restrictive. Therefore, the present disclosure is not limited to what is specifically shown and described herein. Various modifications, substitutions or omissions may be made in forms and details of Implementations without departing from the scope of the present disclosure.

## Claims

1. A display substrate, comprising a plurality of repeating units, wherein at least one repeating unit comprises at least one first power supply line, at least one compensation signal line, at least two data signal line groups and a plurality of sub-pixels, wherein the plurality of sub-pixels form at least two pixel rows and at least two pixel columns, and the data signal line group comprises at least two data signal lines; at least one sub-pixel comprises a pixel driving circuit, which at least comprises a storage capacitor; the first power supply line and the compensation signal line are arranged between two adjacent pixel columns in the repeating unit, and the at least two data signal line groups are arranged on both sides of the repeating unit in a direction of pixel rows, respectively; and the storage capacitor is arranged between the data signal line and the first power supply line, or the storage capacitor is arranged between the data signal line and the compensation signal line.

2. The display substrate according to claim 1, wherein the repeating unit comprises one compensation signal line and two first power supply lines which comprise a first one of first power supply lines and a second one of first power supply lines, the at least two data signal line groups comprise a first data signal line group and a second data signal line group, and the at least two pixel columns comprise a first pixel column and a second pixel column; the compensation signal line is arranged between the first pixel column and the second pixel column in the repeating unit; the first data signal line group is arranged on a side of the first pixel column away from the compensation signal line, and the second data signal line group is arranged on a side of the second pixel column away from the compensation signal line; the first one of first power supply lines is arranged on a side of the compensation signal line close to the first data signal line group, and the storage capacitor in the first pixel column is arranged between the first data signal line group and the first one of first power supply lines; and the second one of first power supply lines is arranged on a side of the compensation signal line close to the second data signal line group, and the storage capacitor in the second pixel column is arranged between the second data signal line group and the second one of first power supply lines.

3. The display substrate according to claim 2, wherein the at least one repeating unit further comprises two power supply connection electrodes, and the power supply connection electrode has a strip shape extending along a direction of the pixel row and is provided across the first pixel column and the second pixel column, wherein one end of the power supply connection electrode is connected to the first one of first power supply lines, and the other end of the power supply connection electrode is connected to the second one of first power supply lines, forming an annular structure for transmitting a first power supply signal within the repeating unit.

4. The display substrate according to claim 1, wherein the at least one repeating unit further comprises a power supply connection electrode, and the power supply connection electrode has a strip shape extending along a direction of the pixel row and is provided across the first pixel column and the second pixel column; and an orthographic projection of the power supply connection electrode on a plane of the display substrate is not overlapped with an orthographic projection of the data signal line on the plane of the display substrate, and the orthographic projection of the power supply connection electrode on the plane of the display substrate is at least partially overlapped with an orthographic projection of the compensation signal line on the plane of the display substrate.

5. The display substrate according to claim 1, wherein the repeating unit comprises one compensation signal line and one first power supply line, the at least two data signal line groups comprise a first data signal line group and a second data signal line group, and the at least two pixel columns comprise a first pixel column and a second pixel column; the compensation signal line is arranged between the first pixel column and the second pixel column in the repeating unit, the first data signal line group is arranged on a side of the first pixel column away from the compensation signal line, and the second data signal line group is arranged on a side of the second pixel column away from the compensation signal line; and the first power supply line is arranged on a side of the compensation signal line close to the second data signal line group, the storage capacitor in the first pixel column is arranged between the first data signal line group and the compensation signal line, and the storage capacitor in the second pixel column is arranged between the second data signal line group and the first power supply line.

6. The display substrate according to claim 5, wherein the storage capacitor at least comprises two electrode plates of capacitor; in the first pixel column, there is a first distance between an edge of at least one electrode plate of the capacitor on a side close to the compensation signal line and an edge of the compensation signal line on a side close to the electrode plate of the capacitor, and in the second pixel column, there is a second distance between an edge of at least one electrode plate of the capacitor on a side close to the first power supply line and an edge of the first power supply line on a side close to the electrode plate of the capacitor, wherein the first distance is greater than or equal to the second distance.

7. The display substrate according to claim 1, wherein the repeating unit comprises one compensation signal line and one first power supply line, the at least two data signal line groups comprise a first data signal line group and a second data signal line group, and the at least two pixel columns comprise a first pixel column and a second pixel column; the compensation signal line is arranged between the first pixel column and the second pixel column in the repeating unit, the first data signal line group is arranged on a side of the first pixel column away from the compensation signal line, and the second data signal line group is arranged on a side of the second pixel column away from the compensation signal line; the first power supply line is arranged on a side of the compensation signal line close to the first data signal line group, the storage capacitor in the first pixel column is arranged between the first data signal line group and the first power supply line, and the storage capacitor in the second pixel column is arranged between the second data signal line group and the compensation signal line.

8. The display substrate according to claim 7, wherein the storage capacitor at least comprises two electrode plates of capacitor; in the first pixel column, there is a second distance between an edge of at least one electrode plate of the capacitor on a side close to the first power supply line and an edge of the first power supply line on a side close to the electrode plate of the capacitor, and in the second pixel column, there is a first distance between an edge of at least one electrode plate of the capacitor on a side close to the compensation signal line and an edge of the compensation signal line on a side close to the electrode plate of the capacitor, and the first distance and the second distance are both greater than a distance between an edge of the compensation signal line on a side close to the first power supply line and an edge of the first power supply line on a side close to the compensation signal line.

9. The display substrate according to claim 1, wherein the repeating unit comprises one first power supply line and two compensation signal lines which comprise a first compensation signal line and a second compensation signal line, the at least two data signal line groups comprise a first data signal line group and a second data signal line group, and the at least two pixel columns comprise a first pixel column and a second pixel column; the first power supply line is arranged between the first pixel column and the second pixel column in the repeating unit, the first data signal line group is arranged on a side of the first pixel column away from the first power supply line, and the second data signal line group is arranged on a side of the second pixel column away from the first power supply line; the first compensation signal line is arranged on a side of the first power supply close to the first data signal line group, and the storage capacitor in the first pixel column is arranged between the first data signal line group and the first compensation signal line; and the second compensation signal line is arranged on a side of the first power supply line close to the second data signal line group, and the storage capacitor in the second pixel column is arranged between the second data signal line group and the second compensation signal line.

10. The display substrate according to claim 9, wherein the at least one repeating unit further comprises two compensation connection electrodes, and the compensation connection electrode has a strip shape extending along a direction of the pixel row and is provided across the first pixel column and the second pixel column, wherein one end of the compensation connection electrode is connected to the first compensation signal line, and the other end of the compensation connection electrode is connected to the second compensation signal line, forming an annular structure for transmitting a compensation signal within the repeating unit.

11. The display substrate according to claim 1, wherein the at least one repeating unit further comprises two compensation connection electrodes, and the compensation connection electrode has a strip shape extending along a direction of the pixel row and is provided across the first pixel column and the second pixel column; and an orthographic projection of the compensation connection electrode on a plane of the display substrate is not overlapped with an orthographic projection of the data signal line on the plane of the display substrate, and the orthographic projection of the compensation connection electrode on the plane of the display substrate is at least partially overlapped with an orthographic projection of the first power supply line on the plane of the display substrate.

12. The display substrate according to claim 1, wherein the repeating unit comprises one compensation signal line and one first power supply line, the at least two data signal line groups comprise a first data signal line group and a second data signal line group, and the at least two pixel columns comprise a first pixel column and a second pixel column; the first power supply line is arranged between the first pixel column and the second pixel column in the repeating unit; the first data signal line group is arranged on a side of the first pixel column away from the first power supply line, and the second data signal line group is arranged on a side of the second pixel column away from the first power supply line; the compensation signal line is arranged on a side of the first power supply line close to the second data signal line group, the storage capacitor in the first pixel column is arranged between the first data signal line group and the first power supply line, and the storage capacitor in the second pixel column is arranged between the second data signal line group and the compensation signal line; or the compensation signal line is arranged on a side of the first power supply line close to the first data signal line group, the storage capacitor in the first pixel column is arranged between the first data signal line group and the compensation signal line, and the storage capacitor in the second pixel column is arranged between the second data signal line group and the first power supply line.

13. The display substrate according to claim 12, wherein the storage capacitor at least comprises two electrode plates of capacitor; in the first pixel column, there is a third distance between an edge of at least one electrode plate of the capacitor on a side close to the first power supply line and an edge of the first power supply line on a side close to the electrode plate of the capacitor, and in the second pixel column, there is a fourth distance between an edge of at least one electrode plate of the capacitor on a side close to the compensation signal line and an edge of the compensation signal line on a side close to the electrode plate of the capacitor; or in the first pixel column, there is a fourth distance between an edge of at least one electrode plate of the capacitor on a side close to the compensation signal line and an edge of the compensation signal line on a side close to the electrode plate of the capacitor, and in the second pixel column, there is a third distance between an edge of at least one electrode plate of the capacitor on a side close to the first power supply line and an edge of the first power supply line on a side close to the electrode plate of the capacitor; and the third distance and the fourth distance are both greater than a distance between an edge of the compensation signal line on a side close to the first power supply line and an edge of the first power supply line on a side close to the compensation signal line.

14. The display substrate according to any one of claims 1 to 13, wherein the storage capacitor at least comprises two electrode plate of capacitors, and in at least one pixel column, the distance between an edge of at least one electrode plate of the capacitor on a side close to the compensation signal line and an edge of the compensation signal line on a side close to the electrode plate of the capacitor is greater than or equal to 3 microns.

15. The display substrate according to any one of claims 1 to 13, wherein the storage capacitor comprises a first electrode plate and a second electrode plate, and the pixel driving circuit further comprises a first transistor, a second transistor and a third transistor, wherein a first electrode of the first transistor is connected to the data signal line, a second electrode of the first transistor is connected to the first electrode plate and a gate electrode of the second transistor, respectively, a first electrode of the third transistor is connected to the compensation signal line, and a second electrode of the third transistor is connected to the second electrode plate and a second electrode of the second transistor, respectively; and in the at least one repeating unit, gate electrodes of a plurality of the first transistors and gate electrodes of a plurality of the third transistors are connected to a same scan signal line.

16. The display substrate according to claim 14, wherein the first transistor at least comprises a first active layer, a first region of the first active layer is connected to the data signal line through a connection electrode, and a second region of the first active layer is connected to the second electrode plate; and in at least one sub-pixel, an orthographic projection of the first active layer on a plane of the display substrate is not overlapped with an orthographic projection of the data signal line on the plane of the display substrate.

17. The display substrate according to claim 14, wherein the third transistor at least comprises a third active layer, a first region of the third active layer is connected to the compensation signal line through a connection electrode, and a second region of the third active layer is connected to the first electrode plate; and in at least one sub-pixel, an orthographic projection of the third active layer on a plane of the display substrate is not overlapped with an orthographic projection of the first power supply line on the plane of the display substrate.

18. A display apparatus, comprising the display substrate according to any one of claims 1 to 17.

19. A method of preparing a display substrate, wherein the display substrate comprises a plurality of repeating units, and the preparation method comprises:
forming at least one first power supply line, at least one compensation signal line, at least two data signal line groups, and a plurality of sub-pixels in at least one repeating unit, wherein the plurality of sub-pixels form at least two pixel rows and at least two pixel columns, and the data signal line group comprises at least one data signal line; at least one sub-pixel comprises a pixel driving circuit, and the pixel driving circuit at least comprises a storage capacitor; the first power supply line and the compensation signal line are arranged between two adjacent pixel columns in the repeating unit, and the at least two data signal line groups are respectively arranged on both sides, in a direction of the pixel rows, of the repeating unit; and the storage capacitor is arranged between the data signal line and the first power supply line, or the storage capacitor is arranged between the data signal line and the compensation signal line.
